(19) Europäisches Patentamt

European Patent Office

Office européen des brevets

(11) EP 1 199 837 B1

(12) EUROPEAN PATENT SPECIFICATION

(45) Date of publication and mention of the grant of the patent:
20.12.2006 Bulletin 2006/51

(51) Int Cl.:
H04L 7/033 (2006.01)   G06F 13/38 (2006.01)

(21) Application number: 01124703.8

(22) Date of filing: 16.10.2001

(54) **Sampling clock generation circuit, data transfer control device, and electronic equipment**

Schaltung zur Erzeugung eines Abtasttaktes, Vorrichtung zum Datentransfer, und elektronische Vorrichtung

Circuit de génération d'horloge d'échantillonage, dispositif de transfer de données, et dispositif électronique

(84) Designated Contracting States:
AT BE CH CY DE DK ES FI FR GB GR IE IT LI LU MC NL PT SE TR

(30) Priority: 19.10.2000 JP 2000319722
30.03.2001 JP 2001098350

(43) Date of publication of application:
24.04.2002 Bulletin 2002/17

(73) Proprietor: SEIKO EPSON CORPORATION
Shinjuku-ku,
Tokyo 163-0811 (JP)

(72) Inventor: Kamihara, Yoshiyuki
Suwa-shi,
Nagano-ken, 392-8502 (JP)

(74) Representative: Hoffmann, Eckart
Patentanwalt,
Bahnhofstrasse 103
82166 Gräfelfing (DE)

(56) References cited:
EP-A- 0 921 654         NN-A-
US-A- 5 687 203

**Description**

TECHNICAL FIELD

The present invention relates to a sampling clock generation circuit, a data transfer control device, and electronic equipment.

BACKGROUND

The Universal Serial Bus (USB) standard has recently attracted attention as an interface standard for connections between personal computers and peripheral equipment (in general: electronic equipment). This USB standard has the advantage of enabling the use of connectors of the same standard to connect peripheral equipment such as a mouse, keyboard, and printer, which are connected by connectors of different standards in the prior art, and of making it possible to implement plug-and-play and hot-plug features.

In comparison with the IEEE 1394 standard that is attracting so much attention as a standard for the same serial bus interface, this USB standard has a problem in that the transfer speed thereof is slower.

In this case, attention is being paid to the decision to use the USB 2.0 standard which can implement data transfer speed at 480 Mbps (HS mode), far faster than those of USB 1.1, while maintaining backward compatibility with the previous USB 1.1 standard. The USB 2.0 transceiver macrocell interface (UTMI), which defined interface specifications for the physical-layer and logical-layer circuitry under USB 2.0, has also been decided upon.

Since data transfer in high-speed (HS) mode under USB 2.0 is at 480 Mbps, it has the advantage that it can be used as an interface for storage devices such hard disk drives or optical disk drives where rapid transfer speeds are required.

However, a data transfer control device connected to USB must generate a high-frequency sampling clock at 480 MHz, in order to sample the data that is transferred thereinto at 480 Mbps. It is also necessary to generate a sampling clock that makes it possible to ensure set-up and hold times during the data sampling. It is therefore extremely difficult to design such a sampling clock generation circuit.

It would be possible in this case to implement such a sampling clock generation circuit by using the latest semiconductor processes which enable microprocessing, but it would be extremely difficult to implement a sampling clock generation circuit that is capable of such fast operation if up-to-date semiconductor processing cannot be used.

One method of implementing a fast sampling clock generation circuit without employing the latest semiconductor processes is a method whereby the circuitry is laid out manually, clock skew is minimized, and synchronization is ensured.

However, this circuit layout and interconnection by manual circuit leads to a longer design period and a higher cost of the resultant device, in comparison with an efficiently circuit design method that utilizes circuit synthesis and automatic interconnection by hardware description language (HDL), and it also hinders the creation of macrocells of the data transfer control device (physical-layer circuitry and logical-layer circuitry).

A sampling clock generation circuit according to the pre-characterizing portion of claim 1 is known from EP-A-0 921 654. In this prior art, the edge detection circuit reads data samples sampled by the first to N-th clocks at the timing of the selected clock and outputs as detection information which includes information concerning the average phase number of rising edges, information concerning the average phase number of falling edges, information concerning the number of rising edges during one cycle of the selected clock, and information concerning the number of falling edges during one cycle of the selected clock (the phase number indicates the timing relative to that of the selected clock). The clock selection circuit selects the clock from the N clocks based on the average phase number of rising edges or the average phase number of falling edges.

Summary

It is an object of the present invention to provide a sampling clock generation circuit that ensures sufficient times such as set-up times during sampling, while operating at a high frequency, together with a data transfer control device and electronic equipment that uses the same.

This object is acieved by a sampling clock generation circuit as claimed in claim 1. Preferred embodiments of the invention are subject-matter of the dependent claims.

The present invention makes it possible to detect whether there is a data edge between any clock edges among the clock edges of first to N-th multi-phase clocks. It is thus possible to detect whether the data edge is between the first and second clocks or between the second and third clocks, by way of example. One clock of the first to N-th clocks is then selected, based on the thus-obtained edge detection information (information indicating there is a data edge between any clock edges of two clocks), and that clock is output as the sampling clock.

The present invention makes it possible to generate a data sampling clock with a simple configuration whereby the selection of a clock from among the first to N-th clocks is based on edge detection information. It therefore makes it possible to generate a sampling clock that is suitable for sampling data (even data that is input in synchronization with a fast clock), using a compact circuit configuration.

When N is set to 5, it becomes possible to select a clock that has a clock edge that is shifted by 2 to 4 clock edges from the data edge, by way of example, thus making it possible to ensure a sufficient selection range as a selection of the clock. If the first to N-th (where N = 5) clocks are to be obtained from outputs of the inversion circuits within the oscillation circuit of a PLL circuit, it is possible to have five stages of inversion circuits, making it possible to induce the oscillation circuit of the PLL circuit to vibrate at a high frequency. As a result, it becomes possible to obtain a high-frequency sampling clock.

With the present invention, the number M is between 2 and 4 to ensure a set-up time and a hold time of a circuit which holds data based on the generated sampling clock. This makes it possible to prevent data sampling errors in the later-stage circuit, thus improving reliability.

With the present invention, it is also possible to obtain suitable edge detection information, even when data that is held in the holding circuit becomes undefined, and thus generate a suitable sampling clock.

With the present invention, it is also possible to generate a sampling clock that is suitable for the configuration of a later-stage circuit, by varying the setting of M, and provide that clock to the later-stage circuit.

A PLL circuit using the sampling clock generation circuit makes it unnecessary to provide separate new circuits for generating the first to N-th clocks, thus making the circuitry smaller.

When the phase differences between the first to N-th clocks are equal (including cases in which they are substantially equal) it is possible to ensure maximum set-up and hold times for the first to N-th holding circuits that hold data based on those first to N-th clocks. This enables effective prevention of sampling and hold errors of the data.

Note that one method that could be considered of disposing the first to N-th inversion circuits to ensure that the phase differences between the first to N-th clocks are equal (including cases in which they are substantially equal) could be a method whereby the first to N-th inversion circuits are disposed along a first line that is parallel to a feedback line thereof (a line connected to the output of the N-th inversion circuit and the input of the first inversion circuit), and also the first to N-th buffer circuits of which inputs are connected to the outputs of the first to N-th inversion circuit are disposed along a second line that is also parallel to the feedback line but different from the first line, by way of example.

One method of interconnecting the output lines of the first to N-th inversion circuits that could be considered in this case is a method whereby first to (N-1)-th dummy lines having parasitic capacitances each of which is equal (including cases in which they are substantially equal) to the feedback line are connected to the first to (N-1) - th inversion circuits, where the feedback line and the first to (N-1)-th dummy lines are disposed in a region between the first to N-th inversion circuits and the first to N-th buffer circuits, by way of example.

When the parasitic capacitances of lines of the first to N-th clocks are equal (including cases in which they are substantially equal) it is possible to ensure that the phase differences between the first to N-th clocks are equal, thus making it possible to maximize the set-up and hold times of the first to N-th holding circuits that hold the data by using these first to N-th clocks. This prevents the generation of data sampling or hold errors, in an efficient manner.

Note that one method that could be considered for ensuring that the parasitic capacitances of the first to N-th clock lines are equal (including cases in which they are substantially equal) is a method whereby the first to N-th clock lines have equal length (including cases in which they are substantially equal), and the same number of loop-back points are provided in the first to N-th clock lines

Since the present invention makes it possible to generate a sampling clock that can reliably sample data to be transferred over a bus, the reliability of data transfer can be increased. In addition, since data to be transferred at a high transfer speed can be sampled reliably, it is possible to implement a data transfer control device that can cope with even a fast bus standard.

Since the present invention makes it possible to reduce the cost and increase the reliability of a data transfer control device used in electronic equipment, it is possible to reduce the cost and increase the reliability of the electronic equipment itself. Since the present invention makes it possible to transfer data at a high speed transfer mode, the processing of electronic equipment comprising the same can also be made faster.

BRIEF DESCRIPTION OF THE DRAWINGS

Fig. 1 shows an example of the configuration of a data transfer control device in accordance with an embodiment of the present invention;
Fig. 2 shows an example of the configuration of the sampling clock generation circuit in accordance with this embodiment of the invention;
Figs. 3A and 3B are timing waveform charts illustrating the operation of this embodiment of the invention;

Fig. 4 shows an example of the configuration of the HSPLL;

Fig. 5 shows an example of the configuration of the VCO;

Figs. 6A and 6B show examples of the configuration of the differential output comparators (inversion circuits);

Fig. 7 shows another example of the configuration of an inversion circuit;

Fig. 8 shows an example of the configuration of the single-end output comparators (buffer circuits);

Fig. 9 shows an example of the configuration of the edge detection circuit and the clock selection circuit;

Fig. 10 is a timing waveform chart illustrating the operation of this embodiment of the invention;

Fig. 11 is a timing waveform chart further illustrating the operation of this embodiment of the invention;

Fig. 12 is illustrative of the method of setting the number of clocks N;

Figs. 13A and 13B are also illustrative of the method of setting the number of clocks N;

Figs. 14A and 14B are illustrative of the clock selection method (the method of setting M);

Fig. 15 shows an example of the configuration of the elasticity buffer;

Fig. 16 is illustrative of the method of arranging the inversion circuits DCP0 to DCP4 and the buffer circuits SCP0 to SCP4;

Fig. 17 is illustrative of the method of arranging feedback and dummy lines in a region between the inversion circuits and the buffer circuits;

Fig. 18 is illustrative of the method of interconnecting clock lines;

Fig. 19 is illustrative of the method of interconnecting clock lines on the multi-phase clock generation circuit (HSPLL) side;

Fig. 20 is illustrative of the method of interconnecting clock lines on the sampling clock generation circuit (HSDLL circuit) side;

Figs. 21A, 21B, and 21C are internal block diagrams of various items of electronic equipment; and

Figs. 22A, 22B, and 22C show typical external views of various items of electronic equipment.

DETAILED DESCRIPTION

Embodiments of the present invention are described below.

Note that the embodiments described below do not in any way limit the gist of the present invention laid out in the claims herein. In addition, all of the configurations described for these embodiments do not limit the components that are essential as requirements of the present invention.

1. Configuration and Operation

1.1 Data Transfer Control Device

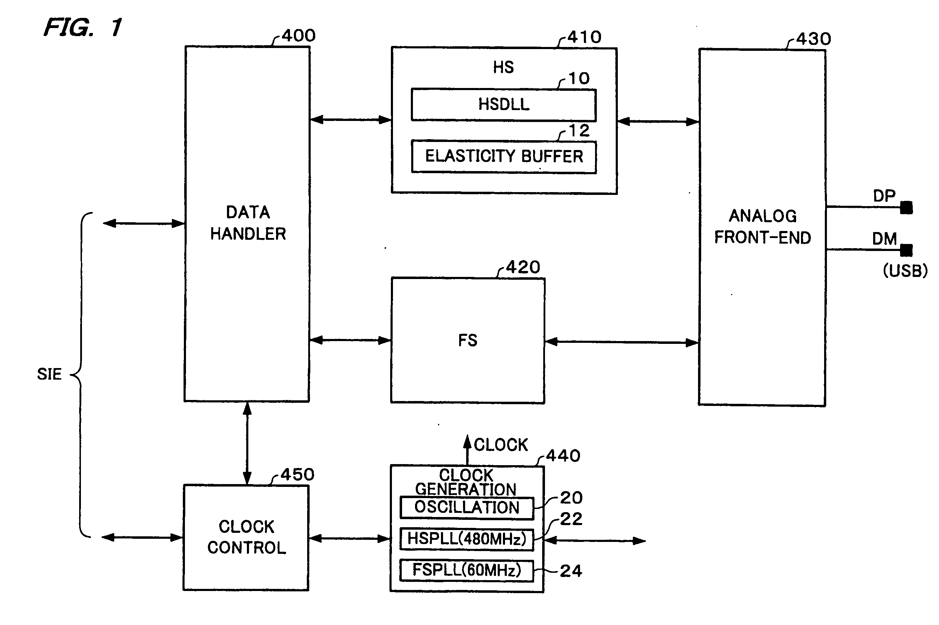

An example of the configuration of a data transfer control device in accordance with the present invention is shown in Fig. 1.

The data transfer control device of this embodiment of the present invention comprises a data handler circuit 400, a high-speed (HS) circuit 410, a full-speed (FS) circuit 420, an analog front-end circuit 430, a clock generation circuit 440, and a clock control circuit 450. Note that not all of the circuit blocks shown in Fig. 1 are necessary for the data transfer control device of the present invention; some of them may be omitted.

The data handler circuit 400 (generally speaking: a given circuit for performing data transfer) performs various types of processing for transferring data in conformation with a standard such as USB. More specifically, during transmission, it performs processing such as attaching synchronization (SYNC), start of packet (SOP), and end of packet (EOP) codes to the data to be transmitted, and bit stuffing. During reception, on the other hand, it performs processing to detect and remove the SYNC, SOP, and EOP codes, and bit unstuffing. In addition is generates various timing signals for controlling the data transfer.

Note that received data is output to a serial interface engine (SIE) that is a stage after the data handler circuit 400, and data to be transmitted is input to the data handler circuit 400 from the SIE.

The HS circuit 410 is a logic circuit for transferring data with a data transfer speed that is a high speed (HS) of 480 Mbps and the FS circuit 420 is a logic circuit for transferring data with a data transfer speed that is a full speed (FS) of 12 Mbps.

In this case, HS mode is a new transfer mode that has been defined by USB 2.0. FS mode, on the other hand, is a transfer mode that was defined previously by the USB 1.1.

Since USB 2.0 provides this HS mode, it makes it possible to implement not only data transfer for devices such as printers, audio equipment, and cameras, but also data transfer in storage devices such as hard disk drives or optical disk (CD-ROM or DVD) drives.

The HS circuit 410 comprises a high-speed delay line PLL (HSDLL) circuit 10 and an elasticity buffer 12.

In this case, the HSDLL circuit 10 is a circuit that generates a data sampling clock based on a reception data and a clock from the clock generation circuit 440 (PLL).

The elasticity buffer 12 is a circuit for absorbing any difference in clock frequency (clock drift) between the internal device (the data transfer control device) and an external device (an external device connected to the bus).

The analog front-end circuit 430 is an analog circuit comprising drivers and receivers for transfer at FS and HS. With USB, data is transferred by a differential signal, using data-plus (DP) and data-minus (DM) signals.

The clock generation circuit 440 generates a 480-MHz clock used within the device and a 60-MHz clock used within the device and by the SIE.

The clock generation circuit 440 comprises an oscillation circuit 20, an HS phase-locked loop (HSPLL 22), and an FS phase-locked loop FSPLL 24.

In this case, the oscillation circuit 20 generates a base clock in combination with a component such as an external oscillator, by way of example.

The HSPLL 22 is a PLL that generates the 480-MHz clock necessary for HS mode and the 60-MHz clock necessary for FS mode, components within the device, and the SIE, based on the base clock generated by the oscillation circuit 20. Note that when transfer is in HS mode, it is necessary to validate clock generation by the HSPLL 22.

The FS Phase Locked Loop (FSPLL) 24 generates the 60-MHz clock necessary for FS mode, components within the device, and the SIE, based on the base clock generated by the oscillation circuit 20. Note that transfer in HS mode is not possible when clock generation by this FSPLL 24 is enabled.

The clock control circuit 450 receives various control signals from the SIE and performs processing such as control of the clock generation circuit 440. Note that the 60-MHz system clock generated by the clock generation circuit 440 is output to the SIE through the clock control circuit 450.

1.2 Sampling Clock Generation Circuit

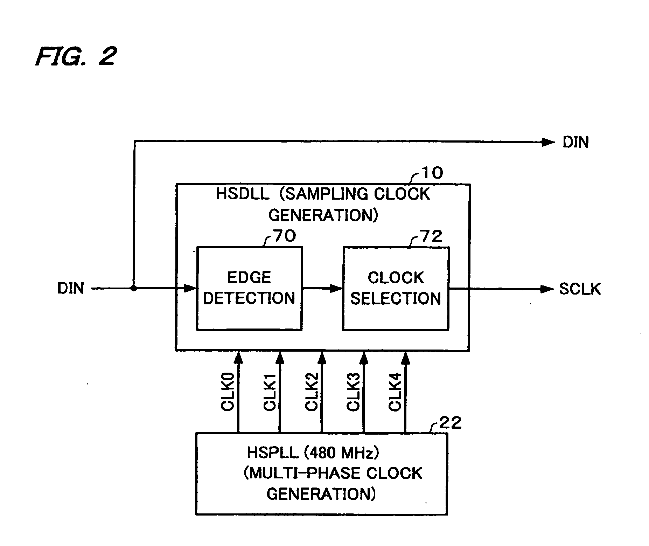

An example of the configuration of the sampling clock generation circuit (HSDLL circuit) in accordance with this embodiment is shown in Fig. 2.

The HSPLL 22 (multi-phase clock generation circuit) outputs clocks CLK0, CLK1, CLK2, CLK3, and CLK4 (generally speaking: first to N-th clocks) of the same frequency but with mutually different phases. More specifically, it uses the outputs of five differential output comparators (generally speaking: first to N-th inversion circuits, in an odd number of stages) comprised by a VCO (an oscillation means with variably controlled oscillation frequency) to generate and output the clocks CLK0 to CLK4.

The HSDLL circuit 10 comprises an edge detection circuit 70 and a clock selection circuit 72. This edge detection circuit 70 (edge detection means) detects a data edge of data DIN that is input from the analog front-end circuit 430 and outputs that edge detection information to the clock selection circuit 72.

More specifically, it detects whether there is a data edge of data DIN between any of either the rising or falling clock edges of CLK0 to CLK4 from the HSPLL 22, and outputs that edge detection information to the clock selection circuit 72.

When that happens, the clock selection circuit 72 selects one of the clocks CLK0 to CLK4 based on that edge detection information, then outputs the selected clock to the elasticity buffer 12 (see Fig. 1) in a later stage as a sampling clock SCLK.

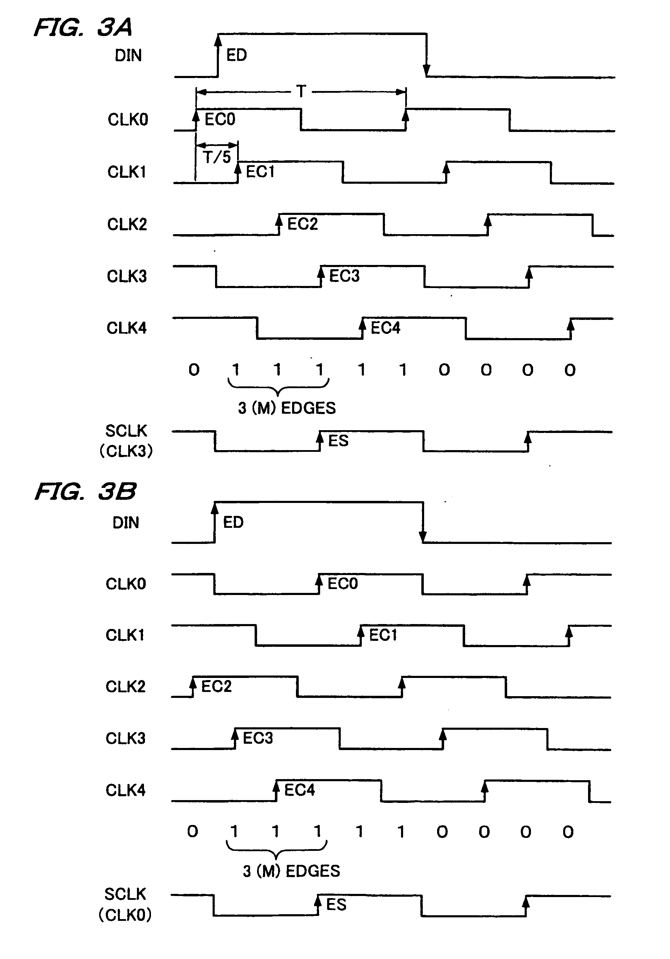

Timing waveform charts shown in Figs. 3A and 3B illustrate the operation of this embodiment of the present invention.

As shown in Figs. 3A and 3B the frequencies of CLK0 to CLK4 are clocks at the same 480 MHz. If the period of each clock is T, the phase between each pair of clocks is T/5 (generally speaking: T/N).

Fig. 3A shows an example in which a data edge ED of the data DIN that is being sampled is detected by the edge detection circuit 70 of Fig. 2 between the clocks CLK0 and CLK1. If that happens, the clock CLK3, which has a clock edge EC3 that is shifted by just three (generally speaking: a set number M) clock edges from the data edge ED of the data DIN, is selected by the clock selection circuit 72 of Fig. 2, and the thus-selected CLK3 is output to the later-stage circuit (the elasticity buffer 12) as the DIN sampling clock SCLK.

In Fig. 3B, on the other hand, the data edge ED of DIN is detected by the edge detection circuit 70 between CLK2 and CLK3. If that happens, the clock CLK0 having a clock edge EC0 that is shifted by just three (generally speaking: the set number M) clock edges from the data edge ED of DIN is selected by the clock selection circuit 72, by way of example, and the thus-selected CLK0 is output to the later-stage circuit (the elasticity buffer 12) as the DIN sampling clock SCLK.

In this manner, the sampling clock SCLK for the data DIN can be selected by a simple configuration in accordance with this embodiment by which the data edge ED of the data DIN is detected and a clock is selected from CLK0 to CLK4, based on the thus-obtained edge detection information. It is therefore possible to generate a clock SCLK that is suitable for sampling DIN, even when DIN is fast transfer data that is synchronized with an external device at 480 MHz.

This embodiment makes it possible to position the clock edge ES of the generated sampling clock SCLK close to the direct center of the data edges of DIN, as shown in Figs. 3A and 3B. Since it is therefore possible to ensure sufficient set-up and hold times for holding data in the later-stage circuit (the elasticity buffer 12), it is possible to greatly increase the reliability of data reception.

In addition, this embodiment utilizes the outputs of the differential output comparators (inversion circuits) within the VCO of the HSPLL 22 as the five-phase (multi-phase) clocks CLK0 to CLK4 used for detecting DINdata edges and generating SCLK. It is therefore unnecessary to provide separate new circuitry for generating CLK0 to CLK4, making it possible to reduce the size of the circuitry.

1.3 Detailed Example of HSPLL

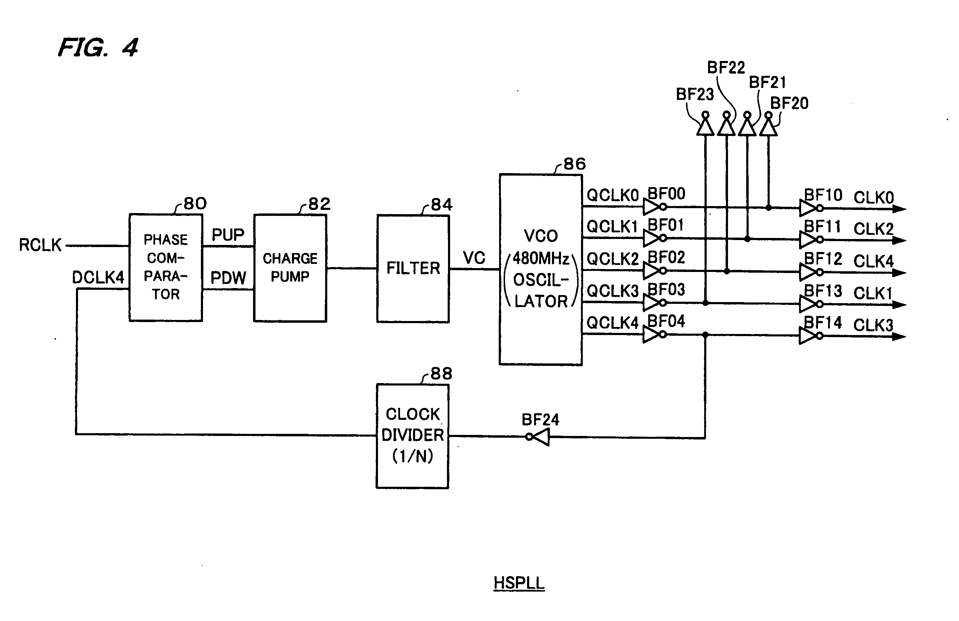

A detailed example of the configuration of the HSPLL 22 is shown in Fig. 4.

This HSPLL 22 comprises a phase comparator 80, a charge pump circuit 82, a filter circuit 84, a voltage-controlled oscillator (VCO) 86, and a clock divider 88.

The phase comparator 80 compares the phases of a base clock RCLK (of, for example, 12 to 24 MHz) and a clock DCLK4 from the clock divider 88, then outputs a phase error signal PUP or PDW (where PUP is a phase-advanced signal and PDW is a phase-retarded signal).

The charge pump circuit 82 operates a charge pump on the basis of the PUP or PDW signal from the phase comparator 80. More specifically, if PUP is active the charge pump circuit 82 charges a capacitor within the filter circuit 84; if PDW is active, it discharges the capacitor. A control voltage VC that has been smoothed by the filter circuit 84 is given to the VCO 86.

The VCO 86 performs an oscillation operation wherein the oscillation frequency is controlled in a variable manner in accordance with the control voltage VC, to generate 480-MHz clocks QCLK0 to QCLK4. If the control voltage VC is high, by way of example, the oscillation frequency also increases; if the control voltage VC is low, the oscillation frequency also decreases.

The clocks QCLK0, QCLK1, QCLK2, QCLK3, and QCLK4 generated by the VCO 86 are output to the exterior as CLK0, CLK2, CLK4, CLK1, and CLK3 through buffer circuits BF00 to BF04 and BF10 to BF14. Note that BF20 to BF23 denote dummy buffer circuits for load-compensation with another buffer circuit BF24.

The clock divider 88 divides (1/N) the clock QCLK4 that is input from the VCO 86 through the buffer circuits BF04 and BF24 and outputs the divided clock DCLK4 to the phase comparator 80.

The HSPLL 22 configured as shown in Fig. 4 is capable of generating a high-frequency 480-MHz clock CLK4 (CLK0 to CLK3) that is phase-synchronized with the base clock RCLK.

Note that the HSPLL 22 of Fig. 4 could also have a configuration such that the charge pump circuit 82 is not provided. Similarly, a current-control oscillation means could be provided instead of the VCO 86.

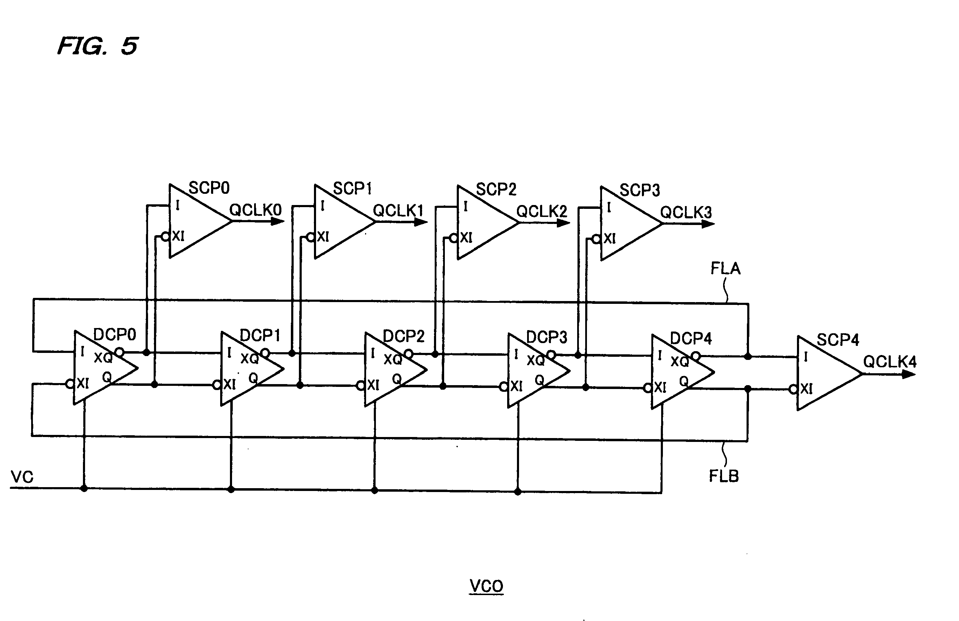

An example of the configuration of the VCO 86 is shown in Fig. 5.

This VCO 86 comprises five stages (generally speaking: an odd number of stages) of serially-connected differential output comparators DCP0 to DCP4 (generally speaking: inversion circuits), such that differential outputs XQ and Q of each of DCP0 to DCP4 are input to differential inputs I and XI of corresponding single-end output comparators SCP0 to SCP4 (generally speaking: buffer circuits) . Outputs of SCP0 to SCP4 become the output clocks QCLK0 to QCLK4 of the VCO 86. In addition, the output of the final-stage differential output comparator DCP4 is connected to the input of the initial-stage differential output comparator DCP0 by feedback lines FLA and FLB (feedback line pair). If the control voltage VC changes, the current flowing through the current source in the differential output comparators DCP0 to DCP4 also changes, so the oscillation frequency changes.

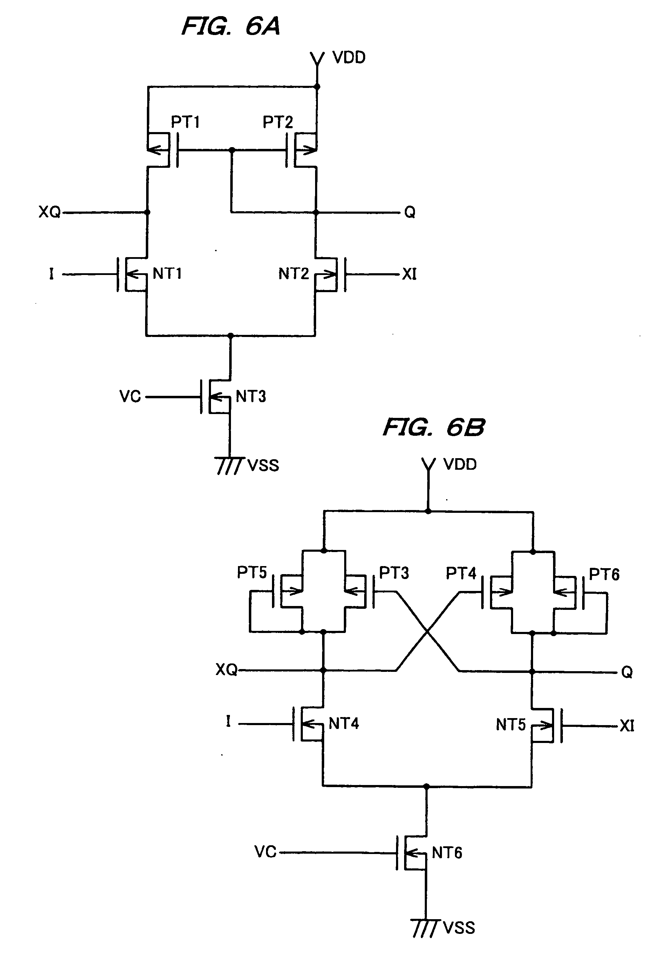

An example of the configuration of the differential output comparators (differential amplifiers) DCP0 to DCP4 is shown in Fig. 6A. Each of these differential output comparators comprises transistors NT1 and NT2, where the differential inputs I and XI are connected to the gate electrodes thereof and the differential outputs XQ and Q are connected to the drain electrodes thereof, and an n-type transistor NT3 (current source), where the control voltage VC is connected to the gate electrode thereof. The differential output comparator also comprises p-type transistors PT1 and PT2, where the differential output Q is connected to both gate electrodes thereof and the differential outputs XQ and Q are connected to the drain electrodes thereof.

Another example of the configuration of the differential output comparators DCP0 to DCP4 is shown in Fig. 6B. Each of these differential output comparators comprises n-type transistors NT4 and NT5, where the differential inputs I and XI are connected to the gate electrodes thereof and the differential outputs XQ and Q are connected to the drain electrodes thereof, an n-type transistor NT6 (current source), where the control voltage VC is connected to the gate electrode thereof. The differential output comparator also comprises p-type transistors PT3 and PT4, where the differential outputs Q and XQ are connected to the gate electrodes thereof and the differential outputs XQ and Q are connected to the drain electrodes thereof, and p-type transistors PT5 and PT6, where the differential outputs XQ and Q are connected to the gate and the drain electrodes thereof.

The circuit of Fig. 6B forms a multi-vibrator type of comparator that has a configuration such that the components on the XQ side (PT3, PT5, and NT4) are line-symmetrical with the components on the Q side (PT4, PT6, and NT5). In other words, if the potential of Q falls, PT3 turns on and the potential of XQ rises, whereas if the potential of XQ falls, PT4 turns on and the potential of Q rises. It is therefore possible to increase the amplitude of the differential outputs Q and XQ more than in the configuration of Fig. 6A (for example, to 1.4 V to 3.2 V).

Note that the inversion circuits comprised within the VCO 86 are not limited to the differential output comparators shown in Figs. 6A and 6B, and thus various other modifications are possible.

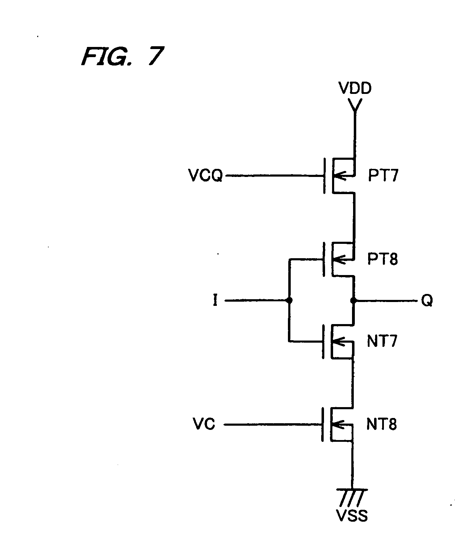

An inversion circuit shown by way of example in Fig. 7 has p-type transistors PT7 and PT8 and n-type transistors NT7 and NT8 connected in series. The current flowing through these transistors is controlled by control voltages VCQ and VC connected to the gate electrodes of PT7 and NT8, so that the oscillation frequency can be controlled in a variable manner.

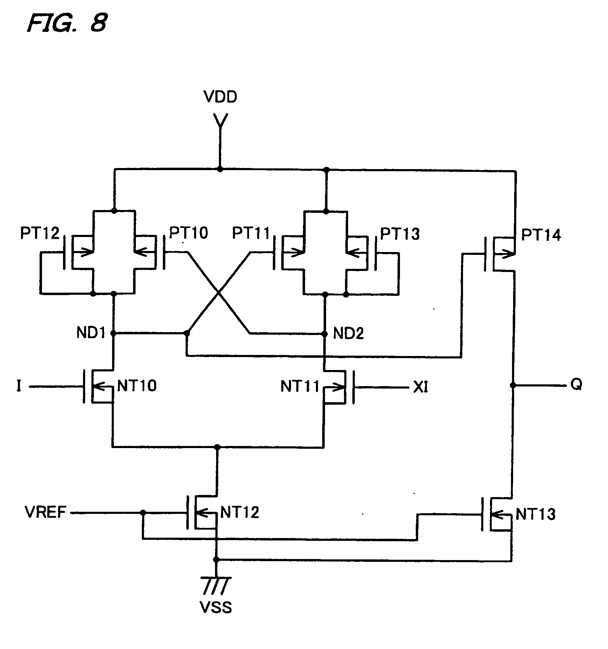

An example of the configuration of the single-end output comparators SCP0 to SCP4 is shown in Fig. 8.

The differential portion of the single-end output comparator shown in Fig. 8 comprises n-type transistors NT10 and NT11, where the differential inputs I and XI are connected to the gate electrodes thereof and nodes ND1 and ND2 are connected to the drain electrodes thereof, and an n-type transistor NT12 (current source), where a reference voltage VREF is connected to the gate electrode thereof. This differential portion also comprises p-type transistors PT10 and PT11, where the nodes ND2 and ND1 are connected to the gate electrodes thereof and the nodes ND1 and ND2 are connected to the drain electrodes thereof, and p-type transistors PT12 and PT13, where the nodes ND1 and ND2 are connected to the gate electrodes and the drain electrodes thereof.

The output portion of the single-end output comparator of Fig. 8 comprises a p-type transistor PT14, where the node ND1 is connected to the gate electrode thereof and the drain electrode is connected to the single-end output Q, and an n-type transistor NT13 (current source), where the reference voltage VREF is connected to the gate electrode thereof and the drain electrode is connected to the single-end output Q.

In the above described embodiment of the present invention, the outputs of the five-stage differential output comparators DCP0 to DCP4 (inversion circuits) of Fig. 5 are used to obtain the five-phase clock CLK0 to CLK4 described with reference to Figs. 2, 3A, and 3B. These differential output comparators DCP0 to DCP4 are essential for the oscillation operation of the VCO 86. Therefore, use of the outputs of those differential output comparators DCP0 to DCP4 in the generation of the five-phase clock CLK0 to CLK4 make it unnecessary to provide separate new circuits for generating CLK0 to CLK4, thus making the circuitry more compact.

1.4 Detailed Example of Edge Detection Circuit and Clock Selection Circuit

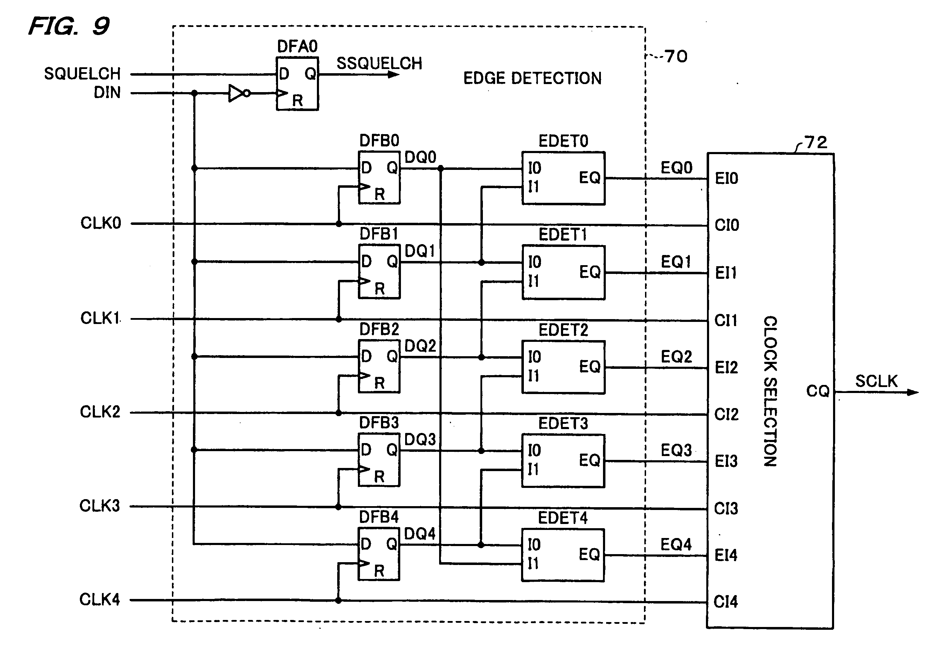

An example of the configuration of the edge detection circuit 70 and the clock selection circuit 72 is shown in Fig. 9.

The edge detection circuit 70 comprises a D flip-flop DFA0, D flip-flops DFB0 to DFB4 (first to N-th holding means), and detection circuits EDET0 to EDET4 (first to N-th detection means).

In this example, the D flip-flop DFA0 samples and holds a signal SQUELCH based on data edges of the data DIN and outputs a signal SSQUELCH.

The D flip-flop DFB0 (the first holding means) samples and holds the data DIN by using the clock edge of the clock CLK0. Similarly, DFB1 (the second holding means) holds DIN by using CLK1, DFB2 (the third holding means) holds DIN by using CLK2, DFB3 (the fourth holding means) holds DIN by using CLK3, and DFB4 (the fifth holding means) holds DIN by using CLK4.

The detection circuits EDET0 to EDET4 perform exclusive-OR operations based on outputs DQ0 to DQ4 (held data) of the D flip-flops DFB0 to DFB4, to detect whether there is a data edge of the data DIN between any of the clock edges of the clocks CLK0 to CLK4.

More specifically, the detection circuit EDET0 (the first detection means) detects whether or not there is a data edge of the data DIN between clock edges of the clocks CLK0 and CLK1, based on the outputs DQ0 and DQ1 of the D flip-flops DFB0 and DFB1. Similarly, EDET1 (the second detection means) detects whether or not there is a data edge of DIN between clock edges of CLK1 and CLK2, based on the outputs DQ1 and DQ2 of DFB1 and DFB2. Furthermore, EDET2 (the third detection means) detects whether or not there is a data edge of DIN between clock edges of CLK2 and CLK3, based on the outputs DQ2 and DQ3 of DFB2 and DFB3, EDET3 (the fourth detection means) detects whether or not there is a data edge of DIN between clock edges of CLK3 and CLK4, based on the outputs DQ3 and DQ4 of DFB3 and DFB4, and EDET4 (the fifth detection means) detects whether or not there is a data edge of DIN between clock edges of CLK4 and CLK0, based on the outputs DQ4 and DQ0 of DFB4 and DFB0.

The clock selection circuit 72 (clock selection means) selects one of the clocks CLK0 to CLK4 on the basis of the outputs EQ0 to EQ4 (edge detection information) of the detection circuits EDET0 to EDET4, and outputs the selected clock as the sampling clock SCLK.

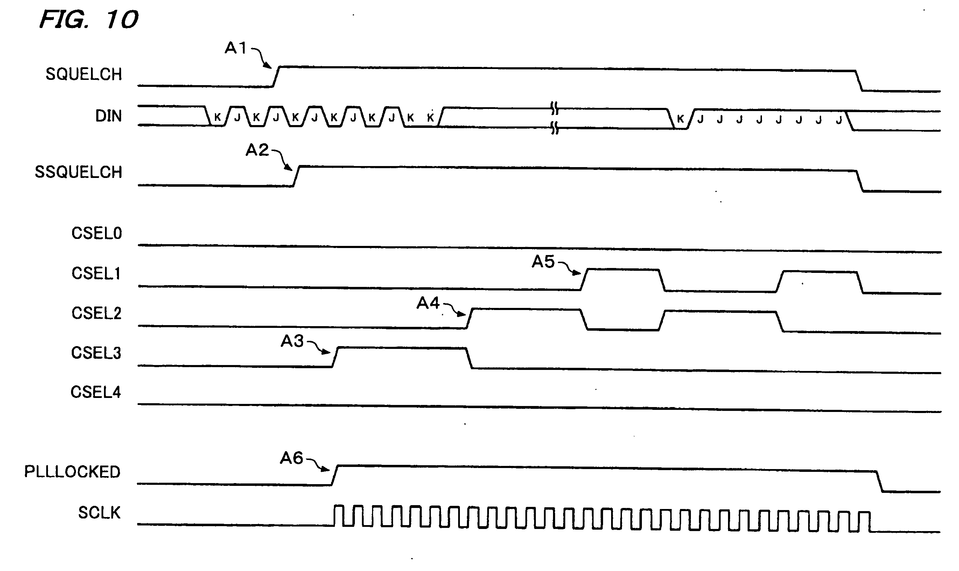

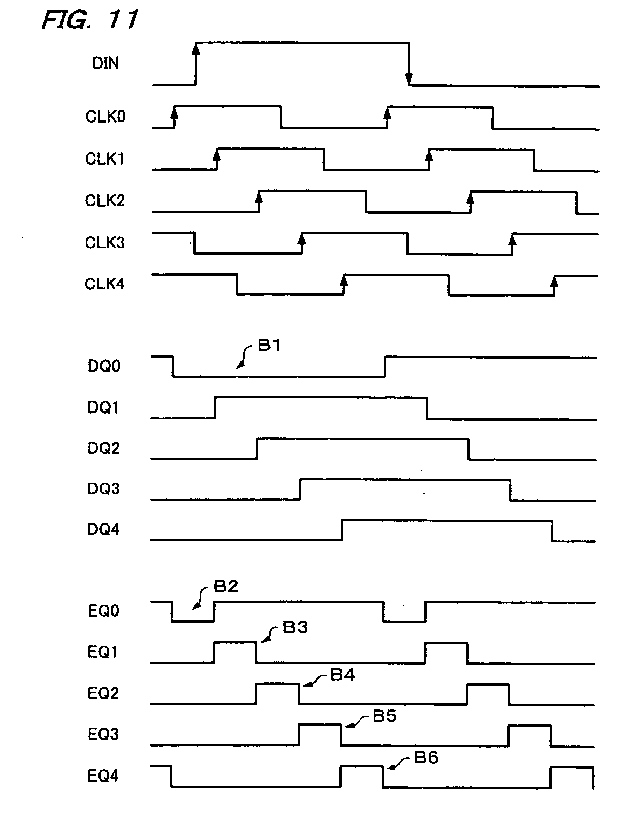

Timing waveform charts shown in Figs. 10 and 11 illustrate the operation of this embodiment.

If the signal SQUELCH, which is used for determining whether or not there is noise in the data DIN, goes to 1 (logic level, hereinafter the same), as shown at A1 in Fig. 10, that is held in the D flip-flop DFA0 of Fig. 9 at the falling data edge of DIN and SSQUELCH also goes to 1, as shown at A2. When SSQUELCH goes to 1, the edge detection operation of the edge detection circuit 70 is enabled.

When that happens, the D flip-flops DFB0 to DFB4 hold the data DIN at the rising clock edges of CLK0 to CLK4 and output DQ0 to DQ4, as shown at B1 in Fig. 11. The detection circuit EDET0 performs an exclusive-OR operation on DQ0 and DQ1, by way of example, and outputs EQ0, as shown at B2. Similarly, the detection circuits EDET1, EDET2, EDET3, and EDET4 perform exclusive-OR operations on DQ1 and DQ2, DQ2 and DQ3, DQ3 and DQ4, and DQ4 and DQ0, to output EQ1 to EQ4.

The clock selection circuit 72 determines which of the clocks CLK0 to CLK4 is to be selected based on these outputs EQ0 to EQ4. Since a data edge of the data is detected between the clock edges of the clocks CLK0 and CLK1 in the example shown at B2 in Fig. 11, the clock CLK4 that has three clock edges (given set number M) from the data edge of DIN is selected (see Fig. 3A) and output as the sampling clock SCLK.

This clock selection can be implemented by a combinational circuit (not shown in the figure) within clock selection circuit 72 that generates clock selection signals CSEL0 to CSEL4 as shown in Fig. 10, then performing logical operations on these CSEL0 to CSEL4 signals and CLK0 to CLK4.

Since the clock selection signal CSEL3 goes active (to 1) at A3 in Fig. 10 in this example, the clock CLK3 is selected and output as the sampling clock SCLK. Similarly, since CSEL2 and CSEL1 go active at A4 and A5, CLK2 and CLK1 are selected in each case, for output as SCLK.

Note that the selection of the clock by the clock selection circuit 72 is enabled on condition that a signal PLLLOCKED, which indicates that the phase synchronization of the HSPLL 22 has been locked, has gone active as shown at A6 in Fig. 10.

1.5 Ensuring of Set-up and Hold Times

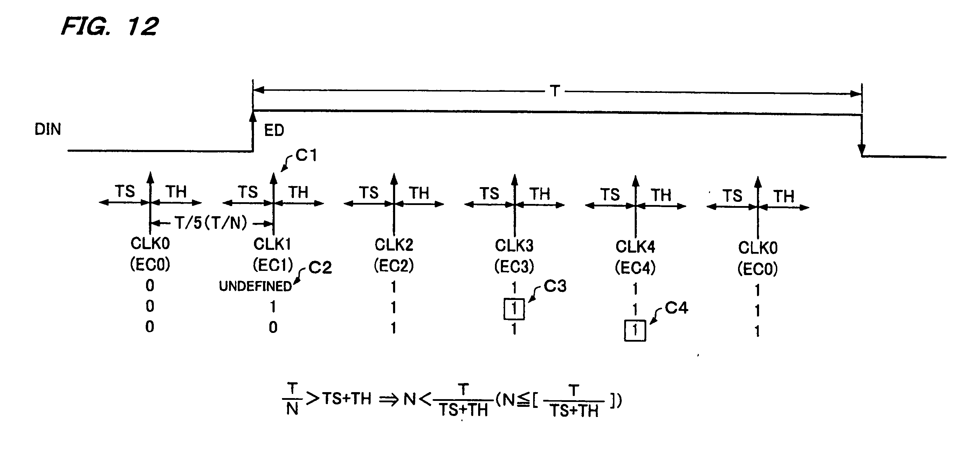

The discussion now considers a case in which the D flip-flops (holding means) DFB0 to DFB4 of Fig. 9 hold the data DIN by using CLK0 to CLK4 at the timing shown in Fig. 12.

In this case, the data edge ED of the data DIN and a clock edge EC1 of CLK1 come close at C1 in Fig. 12, so the set-up time TS for the D flip-flop DFB1 (see Fig. 9) which holds DIN at CLK1 is insufficient. Thus the held data becomes "undefined" at C2 in Fig. 12, so it is not possible to determine whether it is 0 or 1.

In such a case, however, this embodiment ensures that the clock that has a clock edge that is shifted by just three (M) clock edges from the data edge ED of DIN (the position at wich ED is assumed to be detected) is selected as the sampling clock SCLK, as shown at C3 and C4 in Fig. 12, so a suitable SCLK can be generated. In other words, the fetched clock edge of SCLK can be positioned close to the center between the rising data edge and the falling data edge of DIN, as shown at C4 in Fig. 12, even if CLK3 is selected as SCLK as shown at C3 or if CLK4 is selected as SCLK as shown at C4. It is therefore possible for the later-stage circuit (elasticity buffer) to use the thus-generated SCLK to sample and hold DIN.

It should be noted that if the period of the multi-phase clocks CLK0 to CLKN (CLK0 to CLK4) is T, the number of clocks is N (= 5), the set-up time of each D flip-flop (holding means) is TS, and the hold time thereof is TH, the following equation holds:

$$T/N > TS + TH \tag{1}$$

Rearranging Equation (1) gives:

$$N < T/(TS + TH) \tag{2}$$

or:

$$N \le [T/(TS + TH)] \tag{3}$$

where [X] in Equation (3) is the maximum integer that does not exceed X.

If it is assumed by way of example that T = 2.08 nanoseconds (ns) and TS = TP = 0.4 ns, N ≤ 5. In other words, if the number of multi-phase clocks is set to satisfy N ≤ 5 in this case, the set-up and hold times between the multi-phase clocks will not overlap.

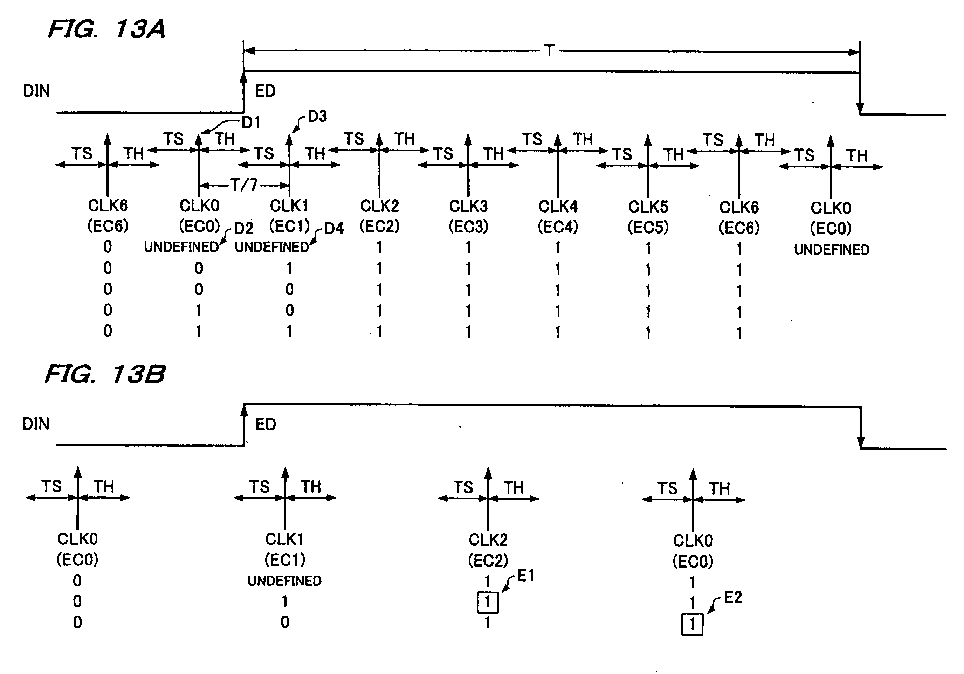

An example in which the number of multi-phase clocks is increased to seven clocks CLK0 to CLK6 is shown in 13A. In other words, if the outputs of the inversion circuits (differential output comparators) within the HSPLL 22 (see Fig. 2) are used as multi-phase clocks, the number of inversion circuit stages is made to be an odd number, to ensure that the VCO oscillates by negative feedback (ring oscillator), and the number of multi-phase clocks is also made odd. Therefore, the next largest number of multi-phase clocks after five is this value of seven. If seven multi-phase clocks CLK0 to CLK6 are used, as shown in Fig. 13A, it is possible that the relationship expressed by Equations (1), (2), and (3) can no longer be satisfied.

Since the data edge ED of DIN and the clock edge EC0 of CLK0 are close at D1 in Fig. 13A, by way of example, the hold time TH for the D flip-flop DFB0 (see Fig. 9) that holds DIN at CLK0 is not sufficient. The held data therefore becomes undefined, as shown at D2, so that it is no longer possible to verify whether it is 0 or 1.

Similarly, the data edge ED of DIN and the clock edge EC1 of CLK1 are close at D3 in Fig. 13A, so the set-up time TS for the D flip-flop DFB1 that holds DIN at CLK1 is not sufficient. This means that the held data becomes undefined, as shown at D4, so that it is no longer possible to verify whether it is 0 or 1.

If there are two points at which this "undefined" occurs, it is not possible to select a suitable clock as the sampling clock SCLK. In other words, although a clock that has a clock edge which is shifted by just three clock edges away from the data edge ED of DIN is selected as SCLK in Fig. 12, by way of example, it is not possible to obtain a suitable SCLK by this selection method in the example shown in Fig. 13A.

In order to prevent such a state, therefore, the number N of multi-phase clocks is set in such a manner as to satisfy the relationship N ≤ [T/(TS + TH)].

An example in which the number of multi-phase clocks is set to three (the next odd number below five) instead of five is shown in Fig. 13B.

If a clock that has a clock edge which is shifted by just two clock edges from the data edge ED of DIN is selected as SCLK, by way of example, CLK2 is selected at E1 in Fig. 13B and CLK0 is selected at E2.

However, only a clock having a clock edge that is shifted by just two clock edges can be selected in the example shown in Fig. 13B, it is not possible to select a clock that has a clock edge shifted by three or four clock edges from the data edge ED of DIN. This method has the disadvantage of a narrow selection range for selectable clocks.

In contrast thereto, the configuration shown in Fig. 12 has the advantage of making it possible to select a clock having a clock edge that is shifted between two and four clock edges from the data edge ED of DIN, thus broadening the selection range for selectable clocks.

Therefore, in order to broaden the selection range of the clock, the number N of multi-phase clocks is preferably made to be the largest possible number while maintaining the relationship: N ≤ [T/(TS + TH)] (where [X] is the maximum integer that does not exceed X). In other words, it is desirable that N = [T/(TS + TH)].

Note that if the number of inversion circuit (differential output comparator) stages within the HSPLL 22 of Fig. 2 is increased, a problem arises in that it is not possible to ensure a high oscillation frequency. If the outputs of such inversions circuits of the HSPLL 22 are used as the multi-phase clocks CLK0 to CLKN, therefore, it is desirable to make the number of number of clocks N larger within the range that can ensure a high oscillation frequency.

More specifically, if N = 5, it becomes possible to select a clock having a clock edge that is shifted by 2 to 4 clock edges from the data edge of the data and a sufficient selection range can be ensured.

If N = 5, on the other hand, the number of inversion circuit stages of the HSPLL 22 can be set to five and high-frequency oscillation of the VCO (oscillation circuit) of the HSPLL 22 can be ensured. As a result, it is possible to obtain a high-frequency sampling clock.

1.6 Clock Selection

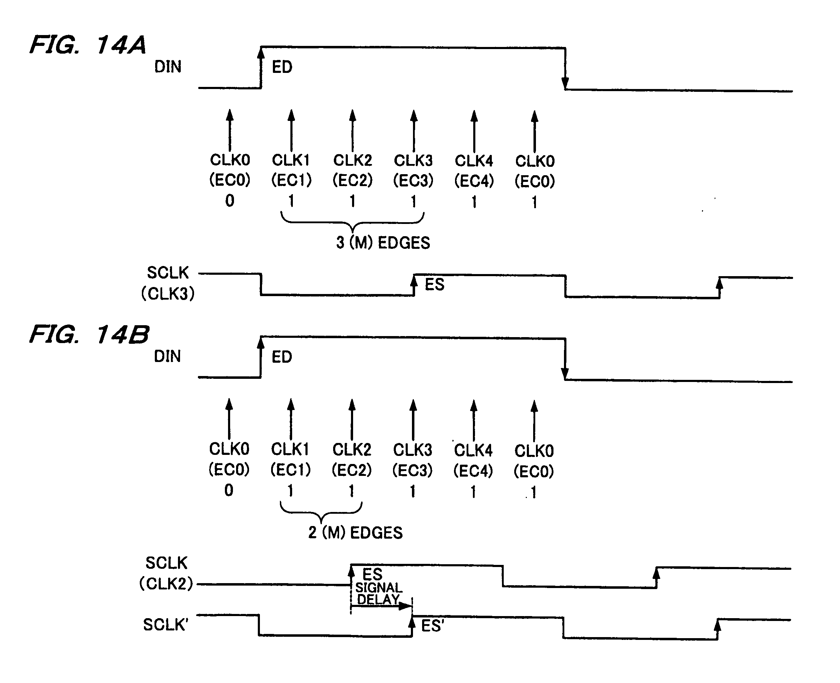

When the sampling clock SCLK generated by the sampling clock generation circuit of this embodiment is used directly in the sampling of the data DIN, it is preferable that a clock that is positioned close to the direct center between rising and falling data edges of DIN is used as SCLK, as shown in Fig. 14A.

If a five-phase clock CLK0 to CLK4 is used, as shown by way of example in Fig. 14A, the clock CLK3 that has a clock edge that is shifted just three (the set number M) clock edges from the data edge ED of the data DIN is selected as the sampling clock SCLK.

This makes it possible to ensure sufficient set-up and hold times when the later-stage circuitry uses the sampling clock SCLK to hold the data DIN.

However, it can happen that the later-stage circuitry does not use the sampling clock SCLK from the sampling clock generation circuit directly but instead uses a clock SCLK' which is obtained by applying a logical operation to SCLK.

In such a case, the position of a clock edge ES' of SCLK' will be delayed beyond the clock edge ES of SCLK, because of element delay caused by the logical operation applied to SCLK, as shown in Fig. 14B.

From consideration of signal delays, therefore, the clock CLK2 having a clock edge that is shifted by just two clock edges from the data edge ED of the data DIN is selected as SCLK, as shown by way of example in Fig. 14B. The later-stage circuit uses SCLK', which is a clock obtained by subjecting this SCLK to a logical operation or the like, for holding the data DIN. This makes it possible to ensure sufficient set-up and hold times when the later-stage circuit holds DIN.

The number of clock edges M of the shift from the data edge ED of DIN is preferably set to be variable in accordance with the configuration of the later-stage circuit.

Note that DIN could also be delayed by a delay element before output to the later-stage circuit, so that the data DIN can be sampled in a suitable manner by SCLK'.

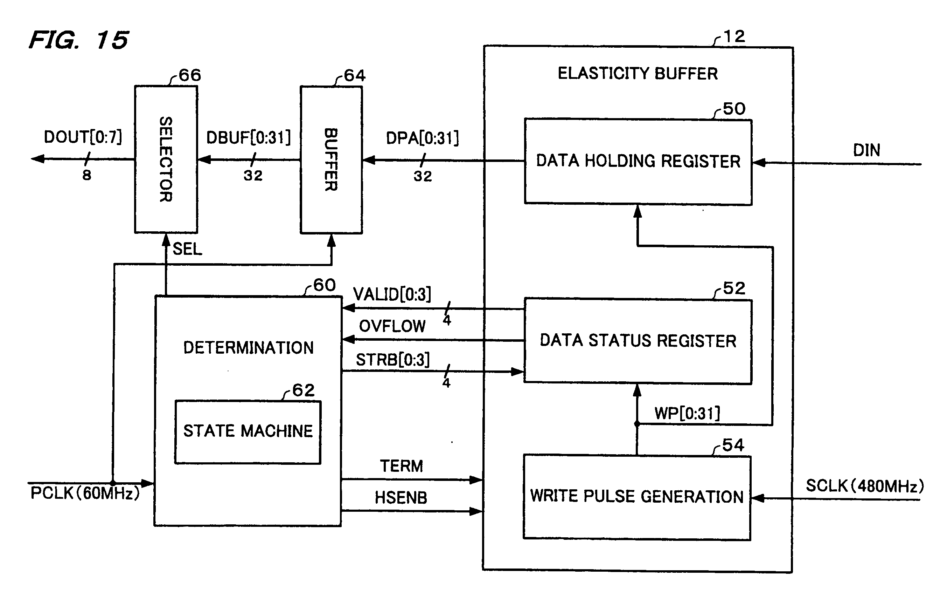

An example of the configuration of the elasticity buffer 12 that is a later-stage circuit is shown in Fig. 15. Note that the elasticity buffer 12 is a circuit comprised within the HS circuit 410, and a determination circuit 60, a buffer 64, and a selector 66 are comprised within another component such as the data handler circuit 400 of Fig. 1, by way of example.

The elasticity buffer 12 comprises a data holding register 50 (data holding means), a data status register 52 (data status holding means), and a write pulse generation circuit 54 (write pulse generation means).

In this case, the data holding register 50 is a 32-bit wide register that receives the serial data DIN and holds it.

The data status register 52 is a 32-bit wide register that holds the status of each bit of data in the data holding register 50.

The write pulse generation circuit 54 generates a 32-bit wide write pulse signal WP [0: 31] and outputs it to the data holding register 50 and the data status register 52.

In this case, the write pulse signal WP [0: 31] is a signal in which each pulse goes active periodically every 32 clock cycles of the sampling clock SCLK (generally speaking: every K-th clock cycle) and the periods at which each pulse goes active are each shifted by one clock cycle. The data holding register 50 holds each bit of data, based on the write pulse signal WP [0: 31]. Similarly, the data status register 52 holds the status of each bit of data, based on the write pulse signal WP[0: 31].

The determination circuit 60 (determination means) is a circuit which determines whether or not data that is held in the data holding register 50 is valid, in data cell units configured of a plurality of bits (such as 8 bits), and which operates in accordance with an internal status machine 62.

More specifically, the determination circuit 60 receives from the data status register 52 a 4-bit wide signal VALID [0: 3] that indicates whether or not each data cell of the data holding register 50 is valid and a signal OVFLOW that becomes active when the data holding register 50 overflows.

It also determines whether or not each data cell is valid and outputs to the selector 66 a signal SEL for selecting valid data cells. It also outputs to the data status register 52 a signal STRB[0: 3] for clearing the data statuses held in the data status register 52, in data cell units. Furthermore, it outputs to the elasticity buffer 12 a signal TERM that goes active at the completion of packet reception in HS mode and a signal HSENB that enables reception in HS mode.

The buffer 64 receives 32-bit wide parallel data DPA[0: 31] from the data holding register 50 and outputs data DBUF[0: 31], which has been synchronized by a 60-MHz clock PCLK and buffered, to the selector 66.

The selector 66 (output means) selects data in valid data cells from the data DBUF[0: 31] from the buffer 64, based on the signal SEL from the determination circuit 60, and outputs it as 8-bit wide data DOUT[0: 7].

The elasticity buffer 12 of Fig. 15 uses the write pulse signal WP[0: 31] from the write pulse generation circuit 54 for the holding of data by the data holding register 50, not SCLK from the sampling clock generation circuit. In other words, the data is held by using WP [0: 31] which is generated by subjecting SCLK to a logical operation or the like. It is therefore desirable to determine the set number M from consideration of element delay due to the write pulse generation circuit 54 when selecting the clock, as described with reference to Figs. 14A and 14B.

1.7 Circuit Layout

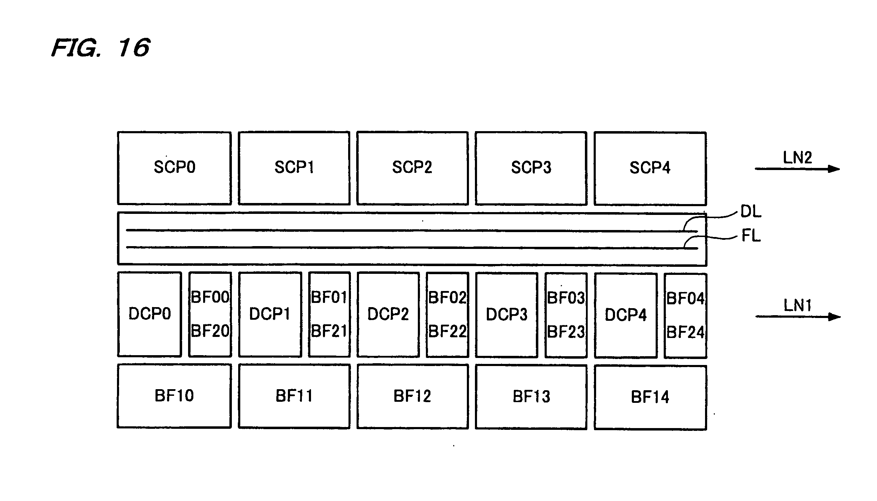

An example of the layout of the inversion circuits DCP0 to DCP4 (differential output comparators) and buffer circuits SCP0 to SCP4 (single-end output comparators) of Fig. 5 and the buffer circuits BF00 to BF04, BF20 to BF24, and BF10 to BF14 of Fig. 4 is shown in Fig. 16.

In Fig. 16, the inversion circuits DCP0 to DCP4 are disposed along a line LN1 (first line) that is parallel to a feedback line FL (the feedback line pair FLA and FLB of Fig. 5), whereas the buffer circuits SCP0 to SCP4 are disposed along a line LN2 (second line) that is also parallel to FL but differs from LN1. This configuration makes it possible to shorten the length of the feedback line FL and reduce the parasitic capacitance of the feedback line FL, in comparison to a method by which the inversion circuits DCP0 to DCP4 and the buffer circuits SCP0 to SCP4 are all disposed along the same line. It is therefore possible to obtain a high-frequency clock and also ensure that the phase differences between the multi-phase clocks (differences in signal delays) are equal (equivalent).

Fig. 16 also shows that the feedback line FL is disposed in a region between the inversion circuits DCP0 to DCP4 and the buffer circuits SCP0 to SCP4. This makes it possible to substitute a line connecting the inversion circuit DCP4 and the buffer circuit SCP4 for the feedback line and prevent the addition of excess parasitic capacitance to the output of the inversion circuit DCP4.

In the configuration shown in Fig. 16, a dummy line DL (DLA0 to DLA3 and DLB0 to DLB3) is provided, and the dummy line DL and the feedback line FL are disposed in the region between the inversion circuits DCP0 to DCP4 and the buffer circuits SCP0 to SCP4. This ensures that the parasitic capacitances of the outputs of the inversion circuits DCP0 to DCP4 can be made equal, making it possible to generate multi-phase clocks having substantially the same phase difference (signal delay difference), but shifted sequentially.

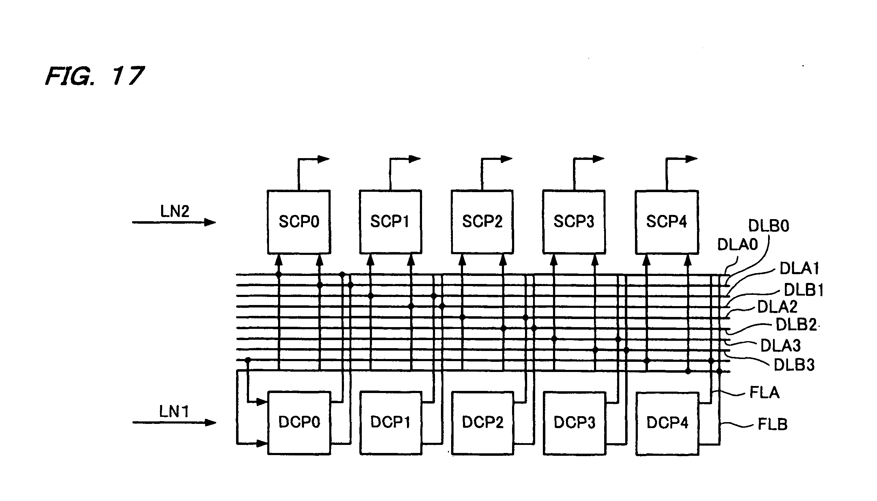

More specifically, as shown in Fig. 17, the outputs of the inversion circuits DCP0 to DCP3 are provided with dummy lines DLA0 to DLA3 and DLB0 to DLB3 (equivalent to DL in Fig. 16), which have parasitic capacitances that are equal (including cases in which they are substantially equal) to the parasitic capacitances of the feedback lines FLA and FLB (equivalent to FL in Fig. 16) connected to the output of the final-stage inversion circuit DCP4. In other words, dummy lines DLA0 to DLA3 and DLB0 to DLB3 (dummy line pairs) of substantially the same length (and same width) as the feedback lines FLA and FLB (feedback line pair) are disposed parallel to the feedback lines FLA and FLB.

This makes it possible to ensure that the parasitic capacitance (line capacitance) of each of the outputs of the inversion circuits DCP0 to DCP3 is equal to the parasitic capacitance of the inversion circuit DCP4, by connecting these dummy lines DLA0 to DLA3 and DLB0 to DLB3 to the inversion circuits DCP0 to DCP3. It is therefore possible to ensure that the phase differences between the multi-phase clocks are equal, enabling the generation of multi-phase clocks having substantially the same phase difference (signal delay difference) that is sequentially shifted. It is thus possible to ensure that the set-up and hold times of the D flip-flops are maximized when these multi-phase clocks are utilized in the generation of a data sampling clock, by way of example. As a result, it is possible to prevent the generation of data sampling or hold errors, enabling the generation of a clock that can be used as appropriate for data sampling.

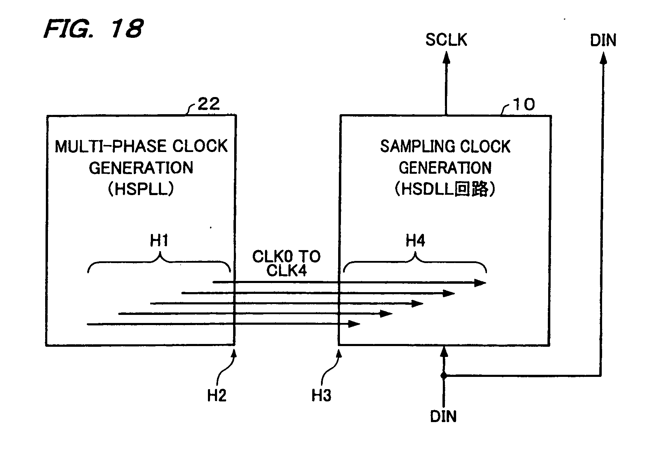

With this embodiment, the sampling clock generation circuit (the HSDLL circuit 10 of Fig. 2) uses the multi-phase clocks CLK0 to CLK4 (first to N-th clocks) generated by the multi-phase clock generation circuit (the HSPLL 22 of Fig. 2) to generate the sampling clock SCLK for sampling the data DIN, as shown in Fig. 18.

The interconnection of the lines CLK0 to CLK4 in accordance with this embodiment is done in such a manner that the parasitic capacitances of the lines of the clocks CLK0 to CLK4 (the lines connected to the outputs of the buffer circuits BF10 to BF14 of Fig. 16) are equal (including cases in which they are substantially equal).

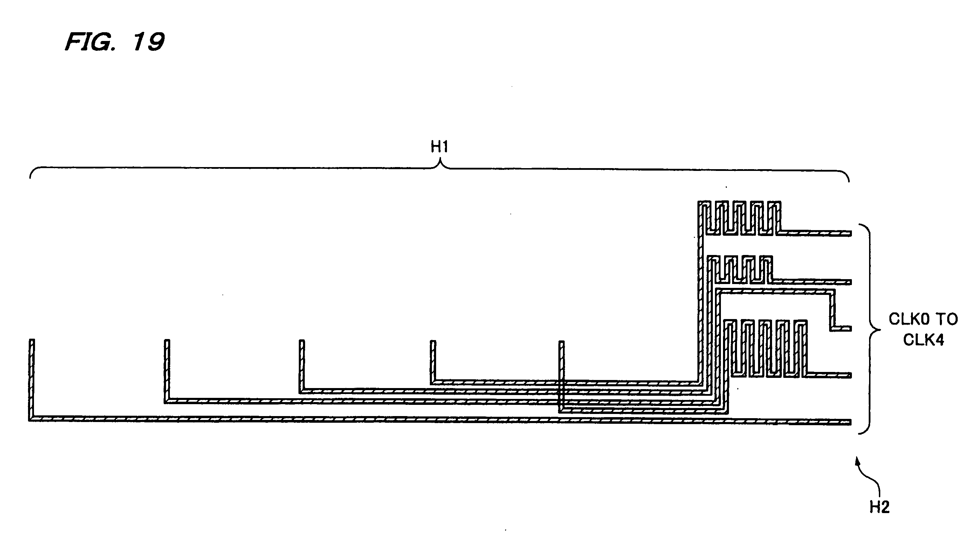

More specifically, the interconnection of the lines for CLK0 to CLK4 on the multi-phase clock generation circuit 22 side of Fig. 18 (the interconnection denoted by H1) could be done as shown in Fig. 19 by way of example. In other words, these lines are made to be deliberately curved, in such a manner that the lengths of the lines of the clocks CLK0 to CLK4 on the multi-phase clock generation circuit 22 side are equal (or substantially equal), as shown in Fig. 19. This configuration makes it possible to ensure that the parasitic capacitances of the lines for CLK0 to CLK4 are equal within the portion up to the output terminals of the multi-phase clock generation circuit 22 (denoted by H2 in Fig. 18).

With this embodiment, the interconnection of CLK0 to CLK4 in the portion from the output terminals of the multi-phase clock generation circuit 22 (denoted by H2) to the input terminals of the sampling clock generation circuit 10 (denoted by H3) is done in such a manner that the parasitic capacitances of the lines for CLK0 to CLK4 are equal. In other words, the lengths of the lines for CLK0 to CLK4 are equal in the portion between H2 and H3.

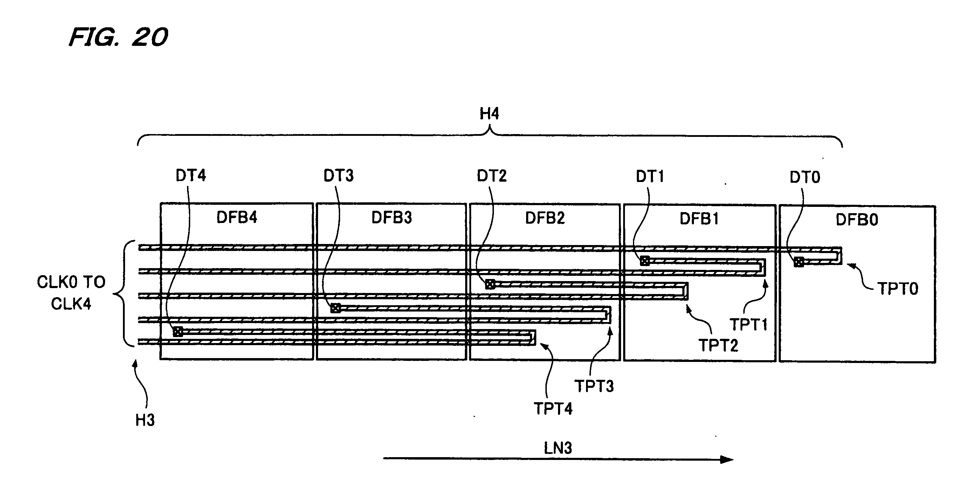

In addition, the interconnection of this embodiment is done in such a manner that the lines for CLK0 to CLK4 (denoted by H4) on the sampling clock generation circuit 10 side of Fig. 18 are wired as shown in Fig. 20 by way of example.

In other words, Fig. 20 shows that the layout ensures that the lengths of the lines for CLK0 to CLK4 are equal from the input terminals of the sampling clock generation circuit 10 (denoted by H3) to the D terminals DT0 to DT4 of the D flip-flops DFB0 to DFB4 (see Fig. 9).

More specifically, the D flip-flops DFB0 to DFB4 (first to N-th holding circuits) that hold the data DIN by using the clocks CLK0 to CLK4 are disposed along a line LN3 that is parallel to the lines for CLK0 to CLK4, as shown in Fig. 20.

The lines for the clocks CLK0 to CLK4 are connected to the corresponding D terminals DT0 to DT4 (DFB0 to DFB4 inputs) of the D flip-flops DFB0 to DFB4 after looping back at loop-back points TPT0 to TPT4 (first to N-th loop-back points). In this case, these loop-back points TPT0 to TPT4 are provided at locations where the parasitic capacitances of the lines for CLK0 to CLK4 are mutually equal.

This configuration makes it possible to ensure that the parasitic capacitances of the lines for CLK0 to CLK4 on the sampling clock generation circuit 10 side are mutually equal.

With the interconnecting method shown in Fig. 20 in particular, where CLK0 to CLK4 are looped back at the loop-back points TPT0 to TPT4 and input to DFB0 to DFB4, it is possible to ensure that there are the same number of loop-backs in each of the lines for CLK0 to CLK4 (for example, number of loop-backs =1). This makes it possible to reduce the differences in capacitances inherent to the lines CLK0 to CLK4 even further.

2. Electronic Equipment

The description now turns to examples of electronic equipment comprising the data transfer control device of this embodiment.

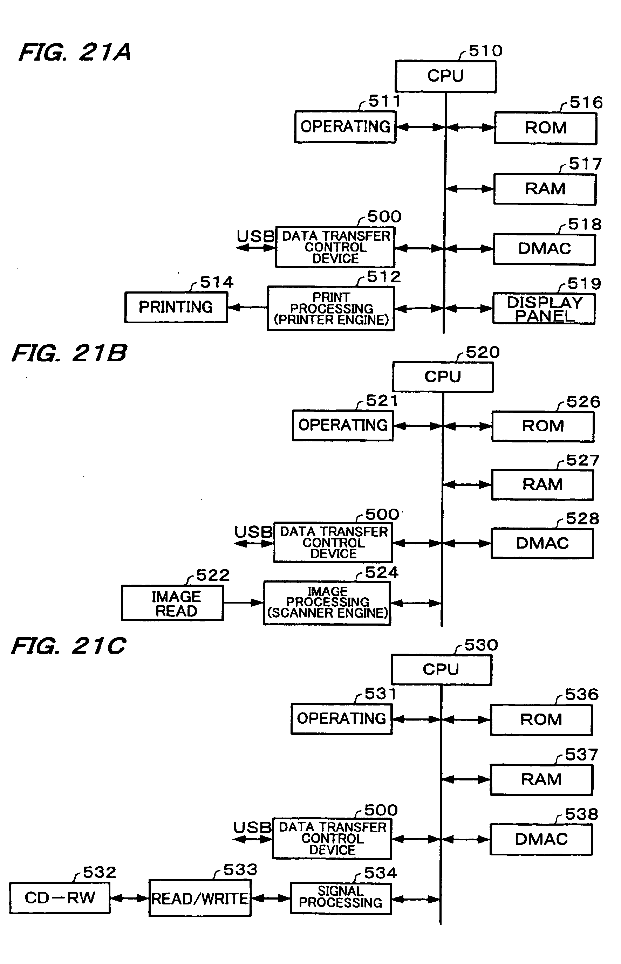

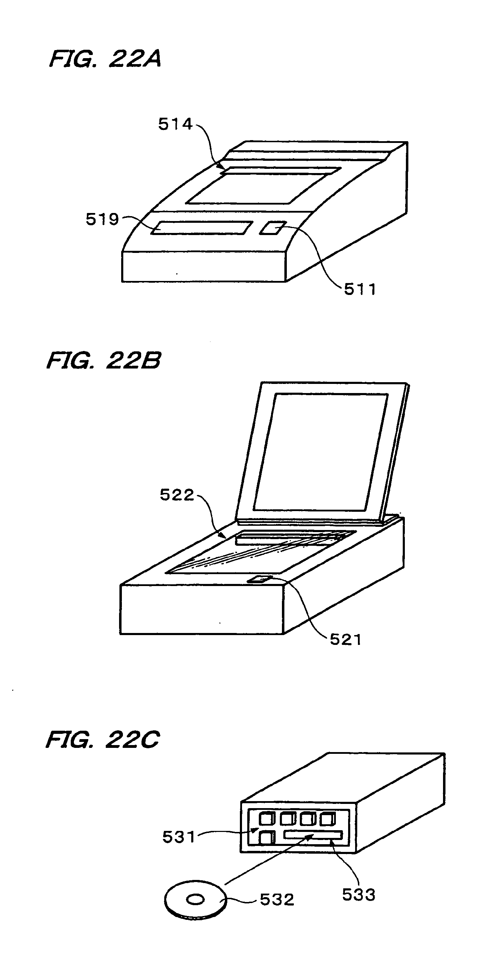

An internal block diagram of a printer that is one example of such electronic equipment is shown in Fig. 21A with an external view thereof being shown in Fig. 22A. A CPU (microcomputer) 510 has various functions, including that of controlling the entire system. An operating section 511 is designed to enable the user to operate the printer. Data such as a control program and fonts is stored in a ROM 516, and a RAM 517 functions as a work area for the CPU 510. A DMAC 518 is a DMA controller for transferring data through the CPU 510. A display panel 519 is designed to inform the user of the operational state of the printer.

Serial print data that has been send in from another device such as a personal computer via USB is converted into parallel print data by a data transfer control device 500. The thus converted parallel print data is sent to a print processing section (a printer engine) 512 by the CPU 510 or the DMAC 518. This parallel print data is subjected to given processing in the print processing section 512 and is output for printing to paper by a printing section (a device for outputting data) 514 comprising components such as a print head.

An internal block diagram of a scanner that is another example of electronic equipment is shown in Fig. 21B with an external view thereof being shown in Fig. 22B. A CPU 520 has various functions, including that of controlling the entire system. An operating section 521 is designed to enable the user to operate the scanner. Data such as a control program is stored in a ROM 526, and a RAM 527 functions as a work area for the CPU 520. A DMAC 528 is a DMA controller.

An image of a document is read in by an image read section (a device for fetching data) 522, which comprises components such as a light source and an opto-electric converter, and data of the read-in image is processed by an image processing section (a scanner engine) 524. The processed image data is sent directly to the data transfer control device 500 by the CPU 520 or DMAC 528. The data transfer control device 500 converts that parallel image data into serial data and sends it to another device such as a personal computer via USB.

An internal block diagram of a CD-RW drive that is a further example of electronic equipment is shown in Fig. 21C with an external view thereof being shown in Fig. 22C. A CPU 530 has various functions, including that of controlling the entire system. An operating section 531 is designed to enable the user to operate the CD-RW drive. Data such as a control program is stored in a ROM 536, and a RAM 537 functions as a work area for the CPU 530. A DMAC 538 is a DMA controller.

Data read out from a CD-RW 532 by a read/write section (a device for fetching data or a device for storing data) 533, which comprises components such as a laser, a motor, and an optical system, is input to a signal processing section 534 where it is subjected to given signal processing such as error correction. The data that has been subjected to this signal processing is sent to the data transfer control device 500 by the CPU 530 or the DMAC 538. The data transfer control device 500 converts this parallel data into serial data, then sends it to another device such as a personal computer via USB.

Serial data that comes in from another device via USB, on the other hand, is converted into parallel data by the data transfer control device 500. This parallel data is sent to the signal processing section 534 by the CPU 530 or the DMAC 538. This parallel data is subjected to given signal processing by the signal processing section 534 then is stored by the read/write section 533 on the CD-RW 532.

Note that a separate CPU for data transfer control by the data transfer control device 500 could be provided in addition to the CPU 510, 520, or 530 of Fig. 21A, 21B, or 21C.

Use of the data transfer control device of this embodiment in electronic equipment makes it possible to transfer data in the HS mode laid down by USB 2.0. When a user uses a personal computer or the like to specify a printout, it is therefore possible to complete printing with a only a small time lag. Similarly, the user can view an image that is read in with only a small time lag after a scanner has been instructed to fetch the image. It is also makes it possible to read data from a CD-RW and write data to a CD-RW at high speed.

Use of the data transfer control device of this embodiment in electronic equipment also enables the fabrication of an IC for the data transfer control device by ordinary semiconductor processes, which have low fabrication costs. It is therefore possible to reduce the price of the data transfer control device and thus reduce the price of the electronic equipment. Since the number of components that operate at high speed during data transfer control can be reduced, it is possible to increase the reliability of data transfer, thus increasing the reliability of the electronic equipment.

Note that the electronic equipment that can employ a data transfer control device in accordance with the present invention is not limited to the above described embodiments, and thus various other examples can be considered, such as various types of optical disk drive (CD-ROM or DVD), magneto-optical (MO) disk drives, hard disk drives, TVs, VCRs, video cameras, audio equipment, telephones, projectors, personal computers, electronic organizers, and dedicated wordprocessors.

Note also that the present invention is not limited to the embodiments described herein, and various modifications are possible within the scope of the invention laid out herein.

For example, the configuration of the data transfer control device in accordance with the present invention is not limited to that shown in Fig. 1.

Similarly, the configurations of the edge detection means (edge detection circuit) and the clock selection means (clock selection circuit) are not limited to those shown in Fig. 7. For example, the edge detection means could be configured in such a manner that it detects at least a data edge and can output that edge detection information to the clock selection means.

In addition, the methods of arranging the inversion and buffer circuits, together with the feedback, dummy, and clock lines, are not limited to the methods shown in Figs. 16 to 20, and thus various equivalent modifications are possible.

Furthermore, the number of multi-phase clocks N is not limited to five. With the latest semiconductor processes used for constructing the sampling clock generation circuit, it may be possible to shorten the set-up time TS and the hold time TH further, by way of example. In such a case, therefore, it would be possible to increase the number of clocks to more than five.

It is particularly desirable to apply the present invention to data transfer under USB 2.0, but it is not limited thereto. For example, the present invention can also be applied to data transfer in accordance with a standard that is based on a concept similar to that of USB 2.0, or a standard that is developed from USB 2.0.

**Claims**

1. A sampling clock generation circuit for generating a sampling clock used for sampling data, the sampling clock generation circuit comprising:

   an edge detection circuit (70) for detecting a data edge; and
   a clock selection circuit (72) for selecting a clock from among first to N-th clocks having the same frequency but mutually different phases, based on detection information from the edge detection circuit (70), and for outputting the selected clock as the sampling clock, where N is a natural number greater than 1,
   wherein the edge detection circuit (70) comprises first to N-th holding circuits (DFB0 to DFB4) adapted to hold data by using the first to N-th clocks, respectively, such that an arbitrary J-th holding circuit (DFB0 to DFB4) holds data by a J-th one of said first to N-th clocks, wherein $1 \leq J \leq N$,
   **characterized in that** $N \leq [T/(TS + TH)]$ wherein TS is a set-up time of the first to N-th holding circuits (DFB0 to DFB4), TH is a hold time of the first to N-th holding circuits (DFB0 to DFB4), and T is the period of each of the first to N-th clocks, [X] representing the maximum integer that does not exceed X, and
   the clock selection circuit (72) is adapted to select from the first to N-th clocks a clock having a clock edge that is shifted by a given number M of clock edges from the detected data edge, M being between 2 and 4.

2. The circuit as defined by claim 1, wherein N is given by $N = [T/(TS + TH)]$.

3. The circuit as defined by claim 1 or 2, wherein N = 5.

4. The circuit as defined by any one of claims 1 to 3, wherein the edge detection circuit (70) comprises:

   first to N-th detection circuits (EDET0 to EDET4) adapted to detect a data edge, such that an arbitrary J-th detection circuit (EDET0 to EDET4) detects whether or not there is a data edge between the clock edges of the J-th clock and the (J+1)-th clock, based on data held in the J-th holding circuit (DFB0 to DFB4) and data held in the (J+1)-th holding circuit (DFB0 to DFB4), wherein $1 \leq J < N$, and such that the N-th detection circuit (EDET0 to EDET4) detects whether or not there is a data edge between the clock edges of the N-th clock and the first clock, based on data held in the N-th holding circuit (DFB0 to DFB4) and data held in the first holding circuit (DFB0 to DFB4), and
   wherein the clock selection circuit (72) is adapted to select a clock from among the first to N-th clocks, based on edge detection information from the first to N-th detection circuits (EDET0 to EDET4).

5. The circuit as defined by any one of claims 1 to 4, further comprising:

   a PLL circuit having an oscillation circuit (20) with a variably-controlled oscillation frequency, and adapted to phase-synchronize a clock generated by the oscillation circuit with a base clock,

   wherein the first to N-th clocks are generated based on outputs of first to N-th inversion circuits of an odd number of stages included in the oscillation circuit.

6. The circuit as defined by claim 5,
wherein at least one of a disposition of the first to N-th inversion circuits (DCP0 to DCP4) and the interconnection of output lines of the first to N-th inversion circuits (DCP0 to DCP4) is such that the phase difference between the i-th clock and the (i+1)-th clock is the same as that between the (i+1)-th clock and the (i+2)-th clock, $1 \leq i \leq (N-2)$.

7. The circuit as defined by claim 5 or 6, wherein lines for the first to N-th clocks are interconnected in such a manner that the parasitic capacitances of lines of the first to N-th clocks are equal.

8. A data transfer control device for providing data transfer over a bus, the data transfer control device comprising:

the sampling clock generation circuit as defined by any one of claims 1 to 7; and
a circuit for holding data, based on the selected one of said N clocks generated by the sampling clock generation circuit, and for performing a given processing for data transfer, based on the held data.

9. The data transfer control device as defined by claim 8, wherein data transfer is in accordance with the Universal Serial Bus "USB" standard.

10. Electronic equipment comprising:

the data transfer control device as defined by claim 8 or 9; and
a device adapted to perform output processing, fetch processing or storage processing on data transferred through the data transfer control device and the bus.


**Patentansprüche**

1. Abtasttaktgeneratorschaltung zur Erzeugung eines Abtasttakts, der zum Abtasten von Daten verwendet wird, wobei die Abtasttaktgeneratorschaltung umfasst:

eine Flankendetektorschaltung (70) zur Erfassung einer Datenflanke;
eine Taktauswahlschaltung (72) zur Auswahl eines Takts unter einem ersten bis N-ten Takt mit gleicher Frequenz aber voneinander verschiedenen Phasen, auf der Basis der Erfassungsinformation von der Flankendetektorschaltung (70), und zur Ausgabe des ausgewählten Takts als des Abtasttakts, wobei N eine natürliche Zahl größer als 1 ist,
wobei die Flankendetektorschaltung (70) eine erste bis N-te Halteschaltung (DFB0 bis DFB4) umfasst, welche ausgebildet sind, Daten jeweils unter Verwendung des ersten bis N-ten Takts zu halten derart, dass eine beliebige J-te Halteschaltung (DFB0 bis DFB4) Daten eines J-ten der ersten bis N-ten Takte hält, wobei $1 \leq J \leq N$ **dadurch gekennzeichnet, dass** $N \leq [T/(TS + TH)]$, wobei TS eine Setup-Zeit der ersten bis N-ten Halteschaltung (DFB0 bis DFB4) ist, TH eine Haltezeit der ersten bis N-ten Halteschaltung (DFB0 bis DFB4) ist und T die Periode jedes der ersten bis N-ten Takte ist und in [X] die größte ganze Zahl darstellt, die X nicht überschreitet, und die Taktauswahlschaltung (72) ausgebildet ist, von dem ersten bis N-ten Takt einen Takt auszuwählen, der eine Taktflanke aufweist, die um eine gegebene Anzahl M von Taktflanken gegenüber der erfassten Datenflanke versetzt ist, wobei M zwischen 2 und 4 liegt.

2. Schaltung nach Anspruch 1, bei der N gegeben ist durch $N = [T/(TS + TH)]$.

3. Schaltung nach Anspruch 1 oder 2, bei der N = 5.

4. Schaltung nach einem der Ansprüche 1 bis 3, bei dem die Flankendetektorschaltung (70) umfasst:

eine erste bis N-te Detektorschaltung (EDET0 bis EDET4), die beschaffen sind, eine Datenflanke zu erfassen derart, dass eine beliebige J-te Detektorschaltung (EDET0 bis EDET4) feststellt, ob oder ob nicht eine Datenflanke zwischen den Taktflanken des J-ten Takts und des (J+1)-ten Takts liegt, und zwar auf der Basis von in der J-ten Halteschaltung (DFB0 bis DFB4) gehaltenen Daten und in der (J+1)-ten Halteschaltung (DFB0 bis DFB4) gehaltenen Daten, wobei $1 \leq J < N$ ist und derart, dass die N-te Detektorschaltung (EDET0 bis EDET4) feststellt, ob oder ob nicht eine Datenflanke zwischen den Taktflanken des N-ten Takts und des ersten Takts liegt und zwar auf der Basis von der N-ten Halteschaltung (DFB0 bis DFB4) gehaltenen Daten und in der ersten Halteschaltung (DFB0 bis DFB4) gehaltenen Daten, und

wobei die Taktauswahlschaltung (72) ausgebildet ist, einen Takt unter den ersten bis N-ten Takten auf der Basis von Flankenerfassungsinformation von der ersten bis N-ten Detektorschaltung (EDET0 bis EDET4) auszuwählen.

5. Schaltung nach einem der Ansprüche 1 bis 4, ferner umfassend:

eine PLL-Schaltung, die eine Oszillatorschaltung (20) mit einer variabel gesteuerten Schwingungsfrequenz aufweist und beschaffen ist, einen von der Oszillatorschaltung erzeugten Takt mit einem Basistakt phasenzusynchronisieren,

wobei der erste bis N-te Takt auf der Basis von Ausgaben einer ersten bis N-ten Inversionsschaltung einer in der Oszillatorschaltung enthaltenen ungeraden Anzahl von Stufen erzeugt werden.

6. Schaltung nach Anspruch 5, bei der wenigstens eines von einer Anordnung der ersten bis N-ten Inversionsschaltungen (DCP bis DCP4) und der Verbindung der ersten bis N-ten Inversionsschaltungen (DCP0 bis DCP4) untereinander so ist, dass die Phasendifferenz zwischen den i-ten Takt und dem (i+1)-ten Takt die gleiche ist wie zwischen dem (i+1)-ten Takt und dem (i+2)-ten Takt, $1 \leq i \leq (N-2)$.

7. Schaltung nach Anspruch 5 oder 6, bei der Leitungen für den ersten bis N-ten Takt so angeschlossen sind, dass die parasitären Kapazitäten der Leitungen des ersten bis N-ten Takts gleich sind.

8. Datenübertragungssteuervorrichtung zum Bewirken einer Datenübertragung über einen Bus, wobei die Datenübertragungssteuervorrichtung umfasst:

eine Abtasttaktgeneratorschaltung nach einem der Ansprüche 1 bis 7; und
eine Schaltung zum Halten von Daten auf der Basis des ausgewählten der N von der Abtasttaktgeneratorschaltung erzeugten Takte, und zur Durchführung einer vorgegebenen Verarbeitung zur Datenübertragung auf der Basis der gehaltenen Daten.

9. Datenübertragungssteuervorrichtung nach Anspruch 8, bei der die Datenübertragung nach Maßgabe des universellen seriellen Bus (USB) Standards erfolgt.

10. Elektronische Einrichtung umfassend:

eine Datenübertragungssteuervorrichtung nach einem der Ansprüche 8 oder 9; und
eine Einrichtung, die in der Lage ist, eine Ausgangsverarbeitung, Abrufverarbeitung oder Speicherverarbeitung an mittels der Datenübertragungssteuervorrichtung und des Busses übertragenen Daten auszuführen.

**Revendications**

1. Circuit de génération d'horloge d'échantillonnage pour engendrer une horloge d'échantillonnage utilisée pour échantillonner des données, le circuit de génération d'horloge d'échantillonnage comprenant :

un circuit (70) de détection de fronts pour détecter un front de données ; et
un circuit (72) de sélection d'horloge pour sélectionner une horloge parmi des première à N-ème horloges ayant la même fréquence mais des phases mutuellement différentes, sur la base d'informations de détection provenant du circuit (70) de détection de fronts, et pour émettre en sortie l'horloge sélectionnée en tant qu'horloge d'échantillonnage, N étant un entier naturel supérieur à 1,
dans lequel le circuit (70) de détection de fronts comprend des premier à N-ème circuits de maintien (DFBO à DFB4), conçus pour maintenir des données en utilisant les première à N-ème horloges, respectivement, de manière à ce qu'un J-ème circuit de maintien arbitraire (DFBO à DFB4) maintienne des données au moyen d'une J-ème horloge parmi les première à N-ème horloges, avec $1 \leq J \leq N$,
**caractérisé en ce que** $N \leq [T/(TS + TH)]$, TS étant un temps d'établissement des premier à N-ème circuits de maintien (DFBO à DFB4), TH étant un temps de maintien des premier à N-ème circuits de maintien (DFBO à DFB4), et T étant la période de chacune des première à N-ème horloges, [X] représentant l'entier maximum qui n'est pas supérieur à X, et

le circuit (72) de sélection d'horloge est conçu pour sélectionner parmi les première à N-ème horloges, une horloge ayant un front d'horloge qui est décalé d'un nombre M donné de fronts d'horloge, à compter du front de données détecté, M étant compris entre 2 et 4.

**2.** Circuit suivant la revendication 1, dans lequel N est donné par N = [T/(TS + TH)].

**3.** Circuit suivant la revendication 1 ou 2, dans lequel N = 5.

**4.** Circuit suivant l'une quelconque des revendications 1 à 3, dans lequel le circuit (70) de détection de fronts comprend :

des premier à N-ème circuits de détection (EDET0 à EDET4), conçus pour détecter un front de données, de manière à ce qu'un J-ème circuit de détection arbitraire (EDET0 à EDET4) détecte s'il existe ou non un front de données entre les fronts d'horloge de la J-ème horloge et de la (J + 1)-ème horloge, sur la base de données maintenues dans le J-ème circuit de maintien (DFB0 à DFB4) et de données maintenues dans le (J + 1)-ème circuit de maintien (DFB0 à DFB4), avec $1 \le J < N$, et de manière à ce que le N-ème circuit de détection (EDET0 à EDET4) détecte s'il existe ou non un front de données entre les fronts d'horloge de la N-ème horloge et de la première horloge, sur la base de données maintenues dans le N-ème circuit de maintien (DFB0 à DFB4) et de données maintenues dans le premier circuit de maintien (DFB0 à DFB4), et

dans lequel le circuit (72) de sélection d'horloge est conçu pour sélectionner une horloge parmi les première à N-ème horloges, sur la base d'informations de détection de fronts provenant des premier à N-ème circuits de détection (EDET0 à EDET4).

**5.** Circuit suivant l'une quelconque des revendications 1 à 4, comprenant en outre :

un circuit PLL ayant un circuit (20) d'oscillation à fréquence d'oscillation commandée de manière variable, et étant conçu pour synchroniser en phase une horloge engendrée par le circuit d'oscillation avec une horloge de base,

dans lequel les première à N-ème horloges sont engendrées sur la base de sorties de premier à N-ème circuits d'inversion d'un nombre impair d'étages compris dans le circuit d'oscillation.

**6.** Circuit suivant la revendication 5,
dans lequel au moins une disposition des premier à N-ème circuits d'inversion (DCP0 à DCP4) ou l'interconnexion de lignes de sortie des premier à N-ème circuits d'inversion (DCP0 à DCP4) est telle que la différence de phase entre l'i-ème horloge et la (i + 1)-ème horloge est identique à celle entre la (i + 1)-ème horloge et la (i + 2)-ème horloge, avec $1 \le i \le (N - 2)$.

**7.** Circuit suivant la revendication 5 ou 6, dans lequel des lignes pour les première à N-ème horloges sont interconnectées de manière à ce que les capacités parasites de lignes des première à N-ème horloges soient égales.

**8.** Dispositif de commande de transfert de données pour permettre un transfert de données sur un bus, le dispositif de commande de transfert de données comprenant :

le circuit de génération d'horloge d'échantillonnage, tel que défini dans l'une quelconque des revendications 1 à 7 ; et

un circuit pour maintenir des données, sur la base de celle sélectionnée des N horloges engendrées par le circuit de génération d'horloge d'échantillonnage, et pour exécuter un traitement donné en vue d'un transfert de données, sur la base des données maintenues.

**9.** Dispositif de commande de transfert de données, suivant la revendication 8, dans lequel le transfert de données s'effectue conformément à la norme USB sur le bus série universel.

**10.** Dispositif électronique comprenant :

le dispositif de commande de transfert de données, tel que défini dans la revendication 8 ou 9 ; et

un dispositif conçu pour exécuter un traitement de sortie, un traitement d'extraction ou un traitement de mémorisation, sur des données transférées au moyen du dispositif de commande de transfert de données et du bus.

*FIG. 1*

EP 1 199 837 B1

## FIG. 2

DIN

**HSDLL (SAMPLING CLOCK GENERATION)** ⌐10

DIN

⌐70
**EDGE DETECTION**

⌐72
**CLOCK SELECTION**

SCLK

CLK0 CLK1 CLK2 CLK3 CLK4

⌐22
**HSPLL (480 MHz) (MULTI-PHASE CLOCK GENERATION)**

*FIG. 3A*

DIN

ED

CLK0

EC0

T

CLK1

T/5

EC1

CLK2

EC2

CLK3

EC3

CLK4

EC4

0   1   1   1   1   1   0   0   0   0

3 (M) EDGES

SCLK
(CLK3)

ES

*FIG. 3B*

DIN

ED

CLK0

EC0

CLK1

EC1

CLK2

EC2

CLK3

EC3

CLK4

EC4

0   1   1   1   1   1   0   0   0   0

3 (M) EDGES

SCLK
(CLK0)

ES

## FIG. 4

HSPLL

FIG. 5

## FIG. 6A

## FIG. 6B

EP 1 199 837 B1

FIG. 7

VDD

VCQ — PT7

PT8

I — Q

NT7

VC — NT8

VSS

23

FIG. 8

## FIG. 9

EP 1 199 837 B1

# FIG. 10

SQUELCH — A1

DIN — K J K J K J K J K J K J K K ... K J J J J J J J J J

SSQUELCH — A2

CSEL0

CSEL1 — A5

CSEL2 — A4

CSEL3 — A3

CSEL4

PLLLOCKED — A6

SCLK

EP 1 199 837 B1

## FIG. 11

DIN

CLK0

CLK1

CLK2

CLK3

CLK4

DQ0    B1

DQ1

DQ2

DQ3

DQ4

EQ0    B2

EQ1    B3

EQ2    B4

EQ3    B5

EQ4    B6

EP 1 199 837 B1

## FIG. 12

$$\frac{T}{N} > TS+TH \Rightarrow N < \frac{T}{TS+TH} \left(N \leq \left[\frac{T}{TS+TH}\right]\right)$$

## FIG. 13A

DIN — ED — T — T/7

D1, D2, D3, D4

| | CLK6 (EC6) | CLK0 (EC0) | CLK1 (EC1) | CLK2 (EC2) | CLK3 (EC3) | CLK4 (EC4) | CLK5 (EC5) | CLK6 (EC6) | CLK0 (EC0) |
|---|---|---|---|---|---|---|---|---|---|
| | 0 | UNDEFINED | UNDEFINED | 1 | 1 | 1 | 1 | 1 | UNDEFINED |
| | 0 | 0 | 1 | 1 | 1 | 1 | 1 | 1 | |
| | 0 | 0 | 0 | 1 | 1 | 1 | 1 | 1 | |
| | 0 | 1 | 0 | 1 | 1 | 1 | 1 | 1 | |
| | 0 | 1 | 1 | 1 | 1 | 1 | 1 | 1 | |

## FIG. 13B

DIN — ED

| | CLK0 (EC0) | CLK1 (EC1) | CLK2 (EC2) | CLK0 (EC0) |
|---|---|---|---|---|
| | 0 | UNDEFINED | 1 | 1 |
| | 0 | 1 | [1] E1 | 1 E2 |
| | 0 | 0 | 1 | [1] |

EP 1 199 837 B1

EP 1 199 837 B1

**FIG. 14A**

DIN

ED

CLK0 (EC0) 0
CLK1 (EC1) 1
CLK2 (EC2) 1
CLK3 (EC3) 1
CLK4 (EC4) 1
CLK0 (EC0) 1

3 (M) EDGES

SCLK (CLK3)

ES

**FIG. 14B**

DIN

ED

CLK0 (EC0) 0
CLK1 (EC1) 1
CLK2 (EC2) 1
CLK3 (EC3) 1
CLK4 (EC4) 1
CLK0 (EC0) 1

2 (M) EDGES

SCLK (CLK2)

ES
SIGNAL DELAY

SCLK'

ES'

FIG. 15

EP 1 199 837 B1

EP 1 199 837 B1

FIG. 16

| SCP0 | SCP1 | SCP2 | SCP3 | SCP4 |
|------|------|------|------|------|

LN2 →

DL
FL

| DCP0 | BF00 BF20 | DCP1 | BF01 BF21 | DCP2 | BF02 BF22 | DCP3 | BF03 BF23 | DCP4 | BF04 BF24 |
|------|------|------|------|------|------|------|------|------|------|

LN1 →

| BF10 | BF11 | BF12 | BF13 | BF14 |
|------|------|------|------|------|

# FIG. 17

*FIG. 18*

SCLK       DIN

22

MULTI-PHASE CLOCK
GENERATION
(HSPLL)

10

SAMPLING CLOCK
GENERATION
(HSDLL回路)

H1

CLK0 TO
CLK4

H4

H2       H3

DIN

*FIG. 19*

EP 1 199 837 B1

H1

CLK0 TO
CLK4

H2

*FIG. 20*

**FIG. 21A**

CPU ⌐510

OPERATING ⌐511

⌐516 ROM

⌐517 RAM

USB DATA TRANSFER CONTROL DEVICE ⌐500

⌐518 DMAC

PRINTING ⌐514

PRINT PROCESSING (PRINTER ENGINE) ⌐512

⌐519 DISPLAY PANEL

**FIG. 21B**

CPU ⌐520

OPERATING ⌐521

⌐526 ROM

⌐527 RAM

USB DATA TRANSFER CONTROL DEVICE ⌐500

⌐528 DMAC

IMAGE READ ⌐522

IMAGE PROCESSING (SCANNER ENGINE) ⌐524

**FIG. 21C**

CPU ⌐530

OPERATING ⌐531

⌐536 ROM

⌐537 RAM

USB DATA TRANSFER CONTROL DEVICE ⌐500

⌐538 DMAC

CD-RW ⌐532

READ/WRITE ⌐533

SIGNAL PROCESSING ⌐534

FIG. 22A

514

519

511

FIG. 22B

522

521

FIG. 22C

531

532    533